# EUROPEAN PATENT APPLICATION

(11) **EP 3 582 078 A1**
(43) Date of publication of application: **18.12.2019**
(21) Application number: 19180137.2
(22) Date of filing: 14.06.2019
(51) Int. Cl.: G06F 3/01

(54) **METHOD AND APPARATUS FOR PROVIDING RESISTIVE FEEDBACK**

(30) Priority: 15.06.2018 US 201816010172
(71) Applicant: Immersion Corporation, San Jose CA 95134 (US)
(72) Inventor: Cruz Hernandez, Juan Manuel, Montreal, Quebec H3Z 1T1 (CA)
(74) Representative: Latscha Schöllhorn Partner AG

(57) **Abstract**

A flexible user interface device comprising a flexible body, a flex sensor, and a control unit is presented. The flex sensor is configured to sense the flexible body receiving an external flexing force. The control unit is configured to detect the flexible body receiving the external flexing force, to determine whether to generate resistive feedback that resists the external flexing force, and to cause the flexible body to increase in stiffness so as to resist the external flexing force. The stiffness is increased via an air sac, a layer of actuatable material such as a macrofiber composite material, electrostatic adhesion, electromagnetic attraction, micro-wedges, or in some other manner.

## Description

### FIELD OF THE INVENTION

The present invention is directed to a method and apparatus for providing resistive feedback, and has application in gaming, consumer electronics, entertainment, and other contexts.

### BACKGROUND

As user interface devices, such as an electronic device for displaying or controlling a virtual environment, become more prevalent, the quality of the interfaces through which humans interact with these environments is becoming increasingly important. Haptic feedback, or more generally haptic effects, can improve the quality of the interfaces by providing cues to users, providing alerts of specific events, or providing realistic feedback to create greater sensory immersion within the virtual environments. Examples of haptic effects include kinesthetic haptic effects on a game controller, or vibrotactile haptic effects on a mobile phone.

### SUMMARY

The following detailed description is merely exemplary in nature and is not intended to limit the invention or the application and uses of the invention. Furthermore, there is no intention to be bound by any expressed or implied theory presented in the preceding technical field, background, brief summary or the following detailed description.

One aspect of the embodiments herein relate to a flexible user interface device, comprising a flexible body; a flex sensor; a sac; an air pump; and a control unit. The flex sensor is disposed within or attached to the flexible body and configured to sense the flexible body receiving an external flexing force. The sac has a flexible membrane, wherein the sac is disposed within the flexible body or attached to a surface thereof, wherein the sac is configured to hold a volume of air and includes a stack of at least two layers of material disposed within the sac, wherein the sac decreases in flexibility when air is pumped out of the sac, and increases in flexibility when air is restored into the sac. The air pump is attached to the sac and configured, when activated, to pump air into or out of the sac. The control unit is in communication with the flex sensor and the air pump, and configured to detect, based on a measurement signal from the flex sensor, the flexible body receiving the external flexing force; in response to detecting the flexible body receiving the external flexing force, to determine whether to generate resistive feedback that resists the external flexing force; and in response to a determination to generate the resistive feedback, to cause the layers of material in the sac to increase in stiffness by activating the air pump to pump air out of the sac.

One aspect of the embodiments herein relate to a flexible user interface device, comprising a flexible body; an actuator; and a control unit. The actuator has a layer of actuatable material and two electrodes disposed on opposite ends of the layer of actuatable material, wherein the actuatable material is configured to generate a stretching force or a contracting force along the layer of actuatable material when a voltage difference is generated between the opposite ends of the actuatable material via the two electrodes, wherein a first surface of the layer of the actuatable material is bonded to the flexible body. The control unit is configured to detect the flexible body receiving a first flexing force that is an external flexing force; in response to detecting the flexible body receiving the external flexing force, to determine whether to generate resistive feedback that resists the external flexing force; and in response to a determination to generate the resistive feedback, to activate the actuator by generating the voltage difference between the opposite ends of the actuatable material via the two electrodes, wherein the voltage difference causes the layer of actuatable material to exert a second flexing force that resists the first flexing force.

One aspect of the embodiments herein relates to a flexible user interface device, comprising a flexible body; a stack of at least a first layer and a second layer that are disposed within the flexible body; a flex sensor; and a control unit. The stack of includes at least one electrode disposed within or bonded to the first layer, wherein the at least one electrode is configured to generate electrostatic adhesion between the first layer and the second layer to prevent the first layer from sliding relative to the second layer and vice versa. The flex sensor is disposed within or attached to the flexible body and configured to sense the flexible body receiving an external flexing force. The control unit is in communication with the flex sensor and configured to detect, based on a measurement signal from the flex sensor, the flexible body receiving the external flexing force; in response to detecting the flexible body receiving the external flexing force, to determine whether to generate resistive feedback that resists the external flexing force; in response to a determination to generate the resistive feedback, to apply an electrical signal to the at least one electrode to generate electrostatic adhesion between the first layer and the second layer and thereby prevent the first layer from sliding relative to the second layer and vice versa. The first layer and the second layer are configured to be able to slide relative to each other when no electrical signal is being provided to the at least one electrode and the flexible body is being flexed.

One aspect of the embodiments herein relates to a flexible user interface device, comprising a flexible body; a stack of at least a first layer and a second layer that are disposed within the flexible body; a flex sensor; and a control unit. The stack includes a first electromagnet disposed within or bonded to the first layer and a second electromagnet disposed within or bonded to the second layer, wherein the first electromagnet and the second electromagnet are configured to generate electromagnetic adhesion between the first layer and the second layer to prevent the first layer from sliding relative to the second layer and vice versa. The flex sensor is disposed within or attached to the flexible body and configured to sense the flexible body receiving an external flexing force. The control unit is in communication with the flex sensor and configured to detect, based on a measurement signal from the flex sensor, the flexible body receiving the external flexing force; in response to detecting the flexible body receiving the external flexing force, to determine whether to generate resistive feedback that resists the external flexing force; in response to a determination to generate the resistive feedback, to apply respective electrical signals to the first electromagnet and the second electromagnet to generate electromagnetic adhesion between the first layer and the second layer and thereby prevent the first layer from sliding relative to the second layer and vice versa. The first layer and the second layer are configured to be able to slide relative to each other when no electrical signal is being provided to at least one of the first electromagnet or the second electromagnet, and the flexible body is being flexed.

One aspect of the embodiments herein relates to a flexible user interface device, comprising: a flexible body; a stack of at least a first layer and a second layer that are disposed within the flexible body; a flex sensor; and a control unit. The first layer includes electrically insulating material and a first electrode bonded to the electrically insulating material. The second layer includes a second electrode that is disposed within or forms the second layer, wherein the first electrode and the second electrode are configured to generate electrostatic adhesion between the first layer and the second layer to prevent the first layer from sliding relative to the second layer and vice versa. The flex sensor is disposed within or attached to the flexible body and configured to sense the flexible body receiving an external flexing force. The control unit is in communication with the flex sensor and configured to detect, based on a measurement signal from the flex sensor, the flexible body receiving the external flexing force; in response to detecting the flexible body receiving the external flexing force, to determine whether to generate resistive feedback that resists the external flexing force; in response to a determination to generate the resistive feedback, to apply a first charge to the first electrode, and to apply a second and opposite charge to the second electrode to generate electrostatic adhesion between the first layer and the second layer and thereby prevent the first layer from sliding relative to the second layer and vice versa. The first layer and the second layer are configured to be able to slide relative to each other when no electrical signal is being provided to first electrode and the second electrode and the flexible body is being flexed.

One aspect of the embodiments herein relates to flexible user interface device, comprising: a flexible body; a stack of a first layer and a second layer disposed within the flexible body; one or more actuators; a flex sensor; and a control unit. The first layer has an array of micro-wedges disposed on a first surface of the first layer. The one or more actuators are configured to actuate the first surface of the first layer toward a second surface of the second layer to engage the first layer and the second layer, wherein the array of micro-wedges are configured to deform when the first and second surfaces are being actuated toward each other, wherein deformation of the array of micro-wedges increases a contact surface area between the array of micro-wedges of the first layer and the second surface of the second layer relative to when the first and second surfaces were not being actuated toward each other, and wherein the first layer and the second layer are configured to slide relative to each other when the one or more actuators are not activated and the flexible body is being flexed. The flex sensor is embedded in or attached to the flexible body and configured to sense the flexible body receiving an external flexing force. The control unit is configured to detect, based on a measurement signal from the flex sensor, the flexing body receiving the external flexing force; in response to detecting the flexible body receiving the external flexing force, to determine whether to generate resistive feedback that resists the external flexing force; and in response to a determination to generate resistive feedback, to activate the one or more actuators to actuate the first surface of the first layer toward the second surface of the second layer or vice versa so as to increase the contact surface area between the array of micro-wedges on the first layer and the second surface of the second layer.

One aspect of the embodiments herein relates to a user interface device, comprising: an elastic body able to undergo deformation that stretches the elastic body; a control unit; and an actuator. The actuator has a flexible substrate bonded to a center of a first surface of a layer of actuatable material, the actuator further having two electrodes disposed on opposite ends of the layer of actuatable material, wherein the actuatable material is configured to generate a stretching force or a contracting force along the layer when a voltage difference is generated between the opposite ends of the actuatable material via the two electrodes. The bonding between the first surface of the layer of actuatable material and the flexible substrate prevents stretching and contracting of the layer of actuatable material at the first surface thereof, or causes the layer of actuatable material to stretch or contract by a smaller magnitude at the first surface thereof than at a second and opposite surface thereof, such that the bonding converts the stretching or contracting force generated by the actuatable material to a bending force on the flexible substrate that bends the flexible substrate into concave or a convex shape. The control unit is configured to determine whether to generate a deformation haptic effect and, in response to the determination to generate the deformation haptic effect, to generate the voltage difference between the opposite ends of the layer of the actuatable material to bend the flexible substrate into the concave or the convex shape, which causes the flexible substrate to stretch the elastic body.

One aspect of the embodiments herein relates to a user interface device, comprising: an elastic body able to undergo deformation that stretches the elastic body; a control unit; and an actuator. The actuator includes a first layer with a first plurality of electrodes disposed on or within the first layer, and includes a second layer with a second plurality of electrodes disposed on or within the second layer, wherein the first layer is slidable relative to the second layer when the actuator is activated. The control unit is configured to activate the actuator by applying charges on the first plurality of electrodes and charges on the second plurality of electrodes in a manner that causes the first plurality of electrodes to be attracted to the second plurality of electrodes in a direction that causes the first layer to slide relative to the second layer or vice versa. The sliding of the first layer relative to the second layer, or vice versa, causes the deformation that stretches the elastic body.

One aspect of the embodiments herein relates to user interface device, comprising: an elastic body able to undergo deformation that stretches the elastic body; a control unit; and an actuator that includes a first layer with a first plurality of electromagnets disposed on or within the first layer, and includes a second layer with a second plurality of electromagnets disposed on or within the second layer, wherein the first layer is slidable relative to the second layer when the actuator is activated. The control unit is configured to activate the actuator by activating the first plurality of electromagnets and the second plurality of electromagnets in a manner that causes the first plurality of electromagnets to be attracted to the second plurality of electromagnets in a direction that causes the first layer to slide relative to the second layer or vice versa. The sliding of the first layer relative to the second layer, or vice versa, causes the deformation that stretches the elastic body.

### BRIEF DESCRIPTION OF THE DRAWINGS

The foregoing and other features, objects and advantages of the invention will be apparent from the following detailed description of embodiments hereof as illustrated in the accompanying drawings. The accompanying drawings, which are incorporated herein and form a part of the specification, further serve to explain the principles of the invention and to enable a person skilled in the pertinent art to make and use the invention. The drawings are not to scale.
FIGS. 1A and 1B depict a flexible user interface device configured to generate resistive feedback via air jamming, according to an embodiment hereof.
FIGS. 2A, 2B, and 3 depict flexible bodies of flexible user interface devices, according to embodiments hereof.
FIGS. 4A-4C depict a flexible user interface device configured to generate resistive feedback via air jamming, according to an embodiment hereof.
FIGS. 5A and 5B depict a flexible user interface device configured to generate resistive feedback via a smart material actuator, according to an embodiment hereof.
FIGS. 6A-6D depict a flexible user interface device configured to generate resistive feedback via a smart material actuator, according to an embodiment hereof.
FIG. 7 depicts a flexible user interface device configured to generate resistive feedback via a smart material actuator, according to an embodiment hereof.
FIG. 8 depicts a flexible user interface device configured to generate resistive feedback via electroadhesion, according to an embodiment hereof.
FIGS. 9A and 9B depict a flexible user interface device configured to generate resistive feedback via electroadhesion, according to an embodiment hereof.
FIGS. 10 and 11 depict flexible user interface devices configured to generate resistive feedback via electroadhesion, according to embodiments hereof.
FIG. 12 depicts a flexible user interface device configured to generate resistive feedback via an array of micro-wedges, according to an embodiment hereof.
FIGS. 13A-13E depict a flexible user interface device configured to generate resistive feedback via an array of micro-wedges, according to an embodiment hereof.
FIGS. 14A-14D depict a foldable user interface device configured to generate resistive feedback, according to an embodiment hereof.
FIG. 15 depicts foldable user interface devices configured to generate resistive feedback, according to embodiments hereof.
FIGS. 16A, 16B, and 17 depict user interface devices that are configured to generate deformation in a normal direction, according to embodiments hereof.
FIGS. 18A, 18B and 19 depict user interface devices that are configured to generate deformation in a lateral direction, according to embodiments hereof.
FIGS. 20A-20E depict a device configured to generate resistive feedback via air jamming, according to an embodiment hereof.
FIGS. 21A and 21B depict a finger bending within a glove, according to an embodiment hereof.

### DETAILED DESCRIPTION

The following detailed description is merely exemplary in nature and is not intended to limit the invention or the application and uses of the invention. Furthermore, there is no intention to be bound by any expressed or implied theory presented in the preceding technical field, background, brief summary or the following detailed description.

One aspect of embodiments described herein relates to providing a haptic effect in the form of resistive feedback. The resistive feedback may be generated for a flexible user interface device, such as a flexible electronic reader (also referred to as an e-reader), a flexible phone, a flexible tablet computer, a flexible remote control device such as a game controller, a wearable device, or any other flexible user interface device. In an embodiment, the resistive feedback may resist an external force that is received at the flexible user interface device. In some cases, the external force may be an external flexing force that is coming from a user. In some instances, the flexible user interface device may be able to receive the external flexing force as a form of user input, such as a flex gesture. Flex gestures are discussed in more detail in U.S. Patent No. 9,411,423 to Heubel, entitled "Method and Apparatus for Haptic Flex Gesturing," the entire content of which is incorporated by reference herein. The flexible user interface device may have sufficient flexibility to undergo gross deformation in response to the external flexing force. The gross deformation may include, e.g., bending, twisting, rolling, or any other deformation that occurs on a macroscopic scale (as opposed to a deformation that is merely on a microscopic scale). The external flexing force may encompass an external torque that a user applies to cause gross deformation of the flexible user interface device.

In an embodiment, resistive feedback may resist such gross deformation. That is, the resistive feedback generated on the flexible user interface device may be a form of haptic feedback, or more generally a form of haptic effect, that resists the external force from the user. In some cases, the resistive feedback can be a completely passive form of feedback that does not actively actuate any portion of the flexible user interface device, but instead only reacts to an external force from a user. That is, the resistive feedback may in some cases be generated only in response to user interaction with the flexible user interface device.

In an embodiment, resistive feedback may further be considered a form of kinesthetic haptic feedback, because it can oppose or otherwise counteract against the external force from the user. In some instances, the resistive feedback is provided by changing a level of stiffness of the flexible user interface device. When the level of stiffness increases, the flexible user interface device may decrease in flexibility and exhibit greater resistance to gross deformation. When a user applies an external force to the flexible user interface device, the increased resistance may convey, e.g., status information, confirmation that a user input has been received or an indication that the user input is invalid, or any other kind of information. For instance, if the flexible user interface device is configured to detect bending gestures, the resistive feedback may create a detent effect that provides confirmation of the user input being received. The detent effect may be created by, e.g., rapidly increasing the level of stiffness of the flexible user interface device and then decreasing the level of stiffness. Such a resistive feedback may allow a user to feel a mechanical click associated with the bending gesture. The user may pull the phone out and find that a friend has sent the user an augmented reality (AR) message. The user may unlock the phone and play the message. The message may be a text message indicating a meeting place with the friend, and may be superimposed on an image of the meeting place. The user may exit the message and bend his or her phone to feel detents while browsing through other messages on the phone.

In an embodiment, resistive feedback may be provided through implementations that use air jamming. Such implementations may provide an airtight sac that has a flexible membrane holding various material or materials. When there is a baseline amount of air pressure in the sac, such as 1 atmosphere (atm) of air pressure, the sac may be flexible and able to undergo gross deformation. When air is removed from the sac, such as via a pump, external pressure on the sac may pack the material in the sac into a smaller space. The material may become stiffer as a result of being packed into a smaller space by the external pressure, thus making the sac as a whole stiffer. When air pressure within the sac has a near-vacuum level, the sac may become substantially stiff, such that the sac is substantially unbendable by typical force magnitudes associated with flex gestures.

In an embodiment, a material in the sac may be provided as a stack of discrete layers, which may be referred to simply as a stack of layers. In some cases, each layer of the stack of discrete layers may be a woven layer. Each of the woven layers may be formed from a plurality of fibers (also referred to as threads) that are interlaced or interweaved with each other. For instance, each of the woven layers may be a layer of cloth or other fabric, in which the fibers may be cotton fibers, linen fibers, polyester fibers, or any other fibers. The fibers may be interlaced or interweaved to form a mesh or any other type of woven configuration. Further, each of the woven layers may be permeable to air. In another embodiment, each layer of the stack is not a woven layer, but may have some other structure. For instance, each layer of the stack may be a sheet of paper or a sheet of plastic. In some cases, the sheet of paper or the sheet of plastic is not permeable to air. Some examples of the total number of layers in the stack of layers may be a number in a range of 2 to 15, 2 to 20, or some other range. In some cases, the material in the sac may be formed as a single layer rather than a stack of layers.

In an embodiment, resistive feedback may be provided through an actuator, such as a smart material actuator, that resists an external force received by a flexible user interface device. For instance, the smart material actuator may be a layer of piezoelectric material, a layer of electroactive polymer (EAP) material, a shape memory alloy (SMA) actuator, or some other smart material actuator. In a more specific example, the smart material actuator may include a layer of macrofiber composite (MFC) material, which may include a plurality of piezoelectric fibers embedded in a polymer matrix. In some implementations, the smart material actuator may be bonded to a surface of the flexible user interface device. When the smart material actuator is activated, the layer of actuatable material may generate a stretching force or a contracting force that tends to stretch or contract the layer of actuatable material along a length or width thereof. The smart material actuator may be bonded to another layer of the flexible user interface device to form, e.g., a unimorph structure. In such a structure, the layer of the flexible user interface device may be substantially less stretchable or less able to contract along a length or width of the layer. As result, a first portion or thickness of the layer of actuatable material that is closer to the flexible user interface device may be prevented from stretching along the length or width of the layer, or may be allowed to stretch by only a small amount, while a second portion or thickness that is farther from the flexible user interface device may be able to undergo more stretching along the length or width of the layer. The difference in the amount of stretching may tend to bend the unimorph structure, by converting the stretching force that is generated by the layer of actuatable material into a bending force. The bending force generated by the smart material actuator may resist an external bending force being applied by a user, and thus may be used to generate resistive feedback. As a result, the smart material actuator may effectively increase a stiffness of the flexible user interface device.

In an embodiment, resistive feedback may be provided by creating electrostatic adhesion or electromagnetic adhesion between at least two separate layers. The electrostatic adhesion or electromagnetic adhesion may engage, or contact, the two layers with each other, or increase an amount of engagement/contact between the two layers. The increased amount of engagement may be reflected in an increased amount of contact surface area between the two layers, or an increased amount of force that is attracting the two layers toward each other. The increased amount of engagement may increase a level of friction between the two layers, which may prevent or restrict sliding movement between the layers. Such sliding of one layer relative to another layer in the stack may occur when the stack is being bent or otherwise deformed, in a manner similar to when a stack of paper sheets is bent. If the layers in the stack are limited in their ability to slide relative to each other, such as due to a high amount of friction therebetween, the stack may behave more as a single structure that is substantially stiff or, more generally, difficult to deform. Thus, the electrostatic or electromagnetic adhesion may be used to increase a level of stiffness of a flexible user interface device, which may be used to generate resistive feedback against an external force that is attempting to bend or otherwise deform the user interface device.

In an embodiment, friction between two layers may be increased via an array of micro-wedges disposed on one or more of the layers, instead of or in addition to electrostatic or electromagnetic adhesion, as discussed above. When the two layers are engaged, or increase in a level of engagement (e.g., a level of attractive force between the two layers), the array of micro-wedges on a first layer may deform so as to expose an increasing amount of surface area to the other, second layer. The increased surface area between the array of micro-wedges of the first layer and a surface of the second layer may increase an amount of friction between the two layers. In an embodiment, each micro-wedge of the array of micro-wedges may have a size that is, e.g., on the order of microns. The array of micro-wedges may mimic behavior of setae on a gecko's foot, which may be able to generate a large amount of friction between the foot and a surface against which the foot is pressed. This behavior may allow the two layers to engage or disengage easily by moving toward or away from each other, but may substantially restrict their ability to slide relative to each other.

In an embodiment, resistive feedback may be generated for a foldable device. For instance, the resistive feedback may be implemented around a hinge of the foldable device, and may resist an external force that is being applied to fold or unfold the foldable device.

In an embodiment, some or all of the components discussed above, such as electrodes or electromagnets used to provide electrostatic or electromagnetic adhesion, may be used to generate an active haptic effect that deforms a user interface device. The deformation may be normal to a length dimension or a width dimension of the user interface device, or may be along the length dimension or the width dimension of the user interface device.

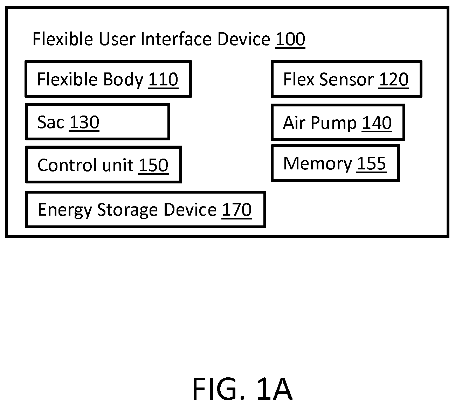

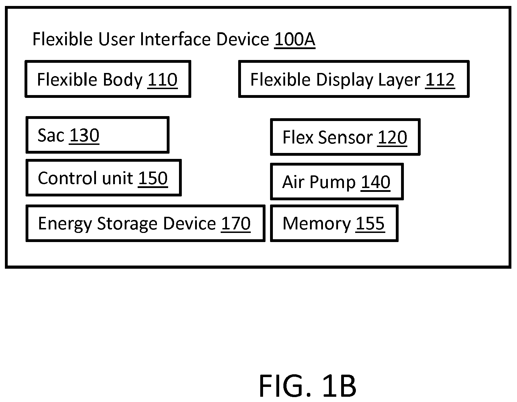

As discussed above, one aspect of embodiments described herein relates to providing resistive feedback via air jamming. FIG. 1A illustrates a block diagram view of a flexible user interface device 100 that is configured to generate resistive feedback using the air jamming technique. The flexible user interface device 100 includes a flexible body 110, a flex sensor 120, a sac 130, an air pump 140, a control unit 150, a memory 155, and an energy storage device 170. In an embodiment, the flexible user interface device 100 is a flexible display device. For instance, FIG. 1B depicts a flexible user interface device 100A that is a more specific embodiment of the flexible user interface device 100. The flexible user interface device 100A includes all of the components illustrated in FIG. 1A, but further include a flexible display layer 112, such as a liquid crystal display (LCD) layer or an organic light emitting device (OLED) layer. The flexible user interface device 100A in FIG. 1B may be, e.g. an e-reader, a mobile phone, a tablet computer, or any other flexible user interface device. In another embodiment, the flexible user interface device 100 has no display layer or display functionality. In such an embodiment, the flexible user interface device 100 may be, e.g., a remote control device such as a game controller, television remote, stereo remote, and/or a wearable device.

In an embodiment, the flexible body 110 may be formed of one or more materials that are sufficiently flexible to be able to undergo gross deformation, and more particularly resilient gross deformation that allows the material to return to an original shape (as opposed to plastic deformation), in response to an external force from a user. The gross deformation may include bending, twisting, rolling, or other macroscopic deformation of the flexible body 110. As an example, the flexible body 110 may be sufficiently flexible to deflect by at least 10 mm when a force of 0.5 N or 1 N is applied thereto. In an embodiment, the flexible body 110 may be a molded component of a plastic material such as polycarbonate, an elastomer such as silicone, and/or any other flexible material.

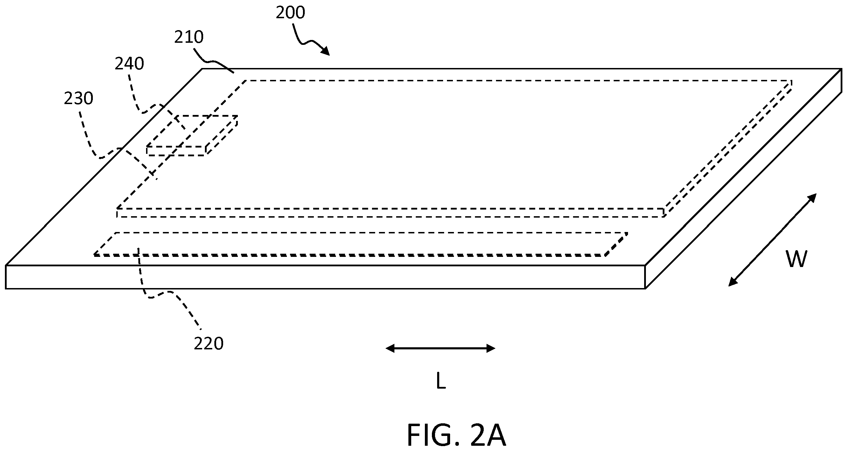

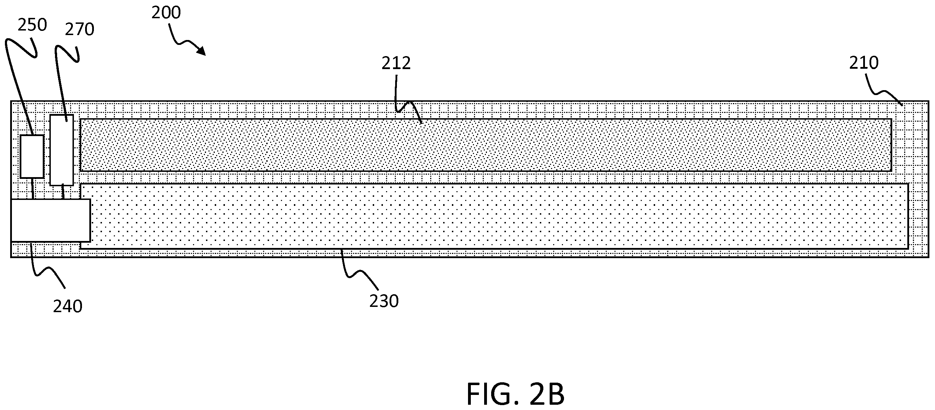

In an embodiment, the flexible body 110 may include a flexible substrate. For instance, FIG. 2A illustrates a flexible body 210 that is a more specific embodiment of the flexible body 110 (the figures herein are not drawn to scale). The flexible body 210 is part of a flexible user interface device 200, which may be an e-reader. In the embodiment of FIGS. 2A and 2B, the flexible body 210 may be a flexible substrate such as a plastic substrate, a silicone substrate, or any other flexible substrate. In some cases, the flexible substrate may be a sheet of plastic, silicone, or other flexible material. Various components of the user interface device 200 may be embedded in or otherwise disposed within the flexible substrate. These components include a sac 230, a pump 240 attached to the sac, and a flex sensor 220, as illustrated in FIG. 2A, and a control unit 250 and an energy storage device 270, as illustrated in FIG. 2B. The flexible user interface device 200 further includes a flexible display layer 212, such as an OLED layer, that is also embedded in the flexible substrate. In an embodiment, the flexible substrate of the flexible body 210 is a transparent substrate. In another embodiment, the flexible substrate is opaque or translucent. For instance, the flexible user interface device 200 may in another embodiment be a remote control device that has no display layer and no display functionality. In such an embodiment, the flexible substrate of the flexible body 210 may be opaque, translucent, or transparent. While FIGS. 2A and 2B illustrate various components of the flexible user interface device 200 being embedded in the flexible substrate of the flexible body 210, in another embodiment some of the embodiments may be bonded or otherwise attached to an outer surface of the flexible substrate. For instance, the sac 230 in such an embodiment may be bonded via an adhesive to an outer surface of the flexible substrate.

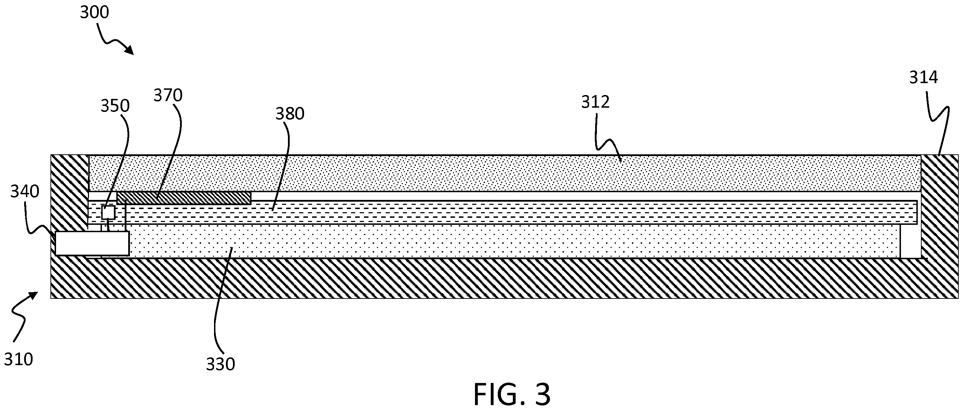

In an embodiment, the flexible body 110 may include a flexible shell. For instance, FIG. 3 depicts a flexible body 310 that is an embodiment of the flexible body 110. The flexible body 310 is part of a flexible user interface device 300, such as a mobile phone or tablet computer. The flexible body 310 may include a flexible shell 314 and a flexible display layer 312, which may together form an enclosure or housing in which various components of the flexible user interface device 300 are disposed. In one example, the flexible shell 314 is a polycarbonate shell, while the flexible display layer 312 is an OLED display layer. The flexible display layer 312 may form, e.g., a front outer surface of the flexible body 310, which may be a surface that faces a user during use. The flexible shell 314 may form a rear outer surface of the flexible body 310, which may be opposite to the front outer surface.

In an embodiment, the enclosure formed by the flexible body 310 may encapsulate a sac 330 and air pump 340 used to provide resistive feedback for the flexible user interface device 300, and encapsulate other components of the flexible user interface device, such as a flexible circuit board 380, a control unit 350, and an flexible energy storage device 370, e.g., a flexible battery. In an embodiment, the sac 330 may be bonded to an inner surface, or more generally an inward-facing surface of the flexible shell 314 of the flexible body 314, or to a surface of the flexible circuit board 380, as illustrated in FIG. 3. In another embodiment, the sac may be bonded to an inward-facing surface of the flexible display layer 312. In yet another embodiment, the sac 330 may be disposed on an outside of the flexible user interface device 300, and may be bonded to the front outer surface or the rear outer surface of the device 300.

In accordance with embodiments hereof, a flexible body 110/210/310 may have various dimensions. In an embodiment, a flexible user interface device 100 may be a mobile phone, and the flexible body 100 may have a length that is between 140 mm and 165 mm, a width that is between 65 mm and 85 mm, and a thickness between 4 mm and 9 mm. In an embodiment, the flexible user interface 100 may have a weight that is in a range between 100 g to 200 g, or in another range.

In an embodiment, a flexible user interface device 100 may be a wearable device. For instance, the flexible user interface device may be a glove used to control a gaming or virtual reality (VR) environment. The resistive feedback discussed herein may be used to control a level of stiffness of the glove.

Referring back to FIGS. 1A and 1B, the flex sensor 120 is configured to sense an external flexing force being received at the flexible body 110. The external flexing force may be a force or torque that would cause gross deformation of the flexible user interface 100 in the absence of any resistive feedback (or even with resistive feedback). For instance, the flex sensor 120 may be configured to sense bending, twisting, rolling, or other flexing (or, more generally, gross deformation) of the flexible body 110 of the flexible user interface device 100 due to the external flexing force. FIG. 2A illustrates a flex sensor 220 that is a more specific embodiment of the flex sensor 120. The flex sensor 220 may be strain gauge having an elongated shape, such as a strip, and may be aligned along a length L (as shown) or a width W of the flexible body 210 of the flexible user interface device 200. In an embodiment, the flex sensor 220 may be configured to measure a magnitude of deformation of the flexible body 210, which may be an indirect way of measuring a magnitude of an external flexing force that is applied to the flexible body 210. In an embodiment, the flex sensor 220 may be embedded within the flexible substrate of the flexible body 210, as illustrated in FIG. 2A, or may be attached to an outer surface of the flexible body 210. In another embodiment involving a flexible body 110/310 having a flexible shell 314, as illustrated in FIG. 3, the flexible user interface device 300 thereof may have a flex sensor bonded to an inward-facing surface or an outer surface of the flexible shell 314.

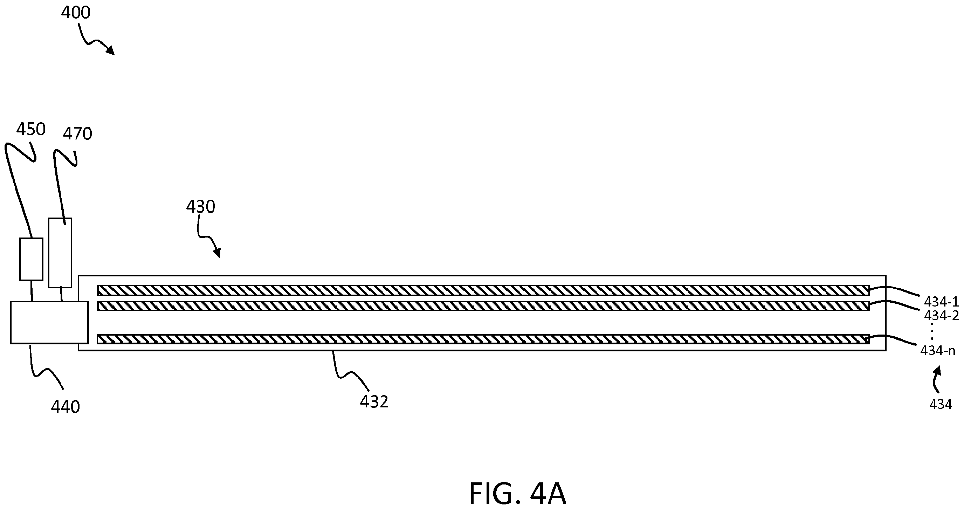

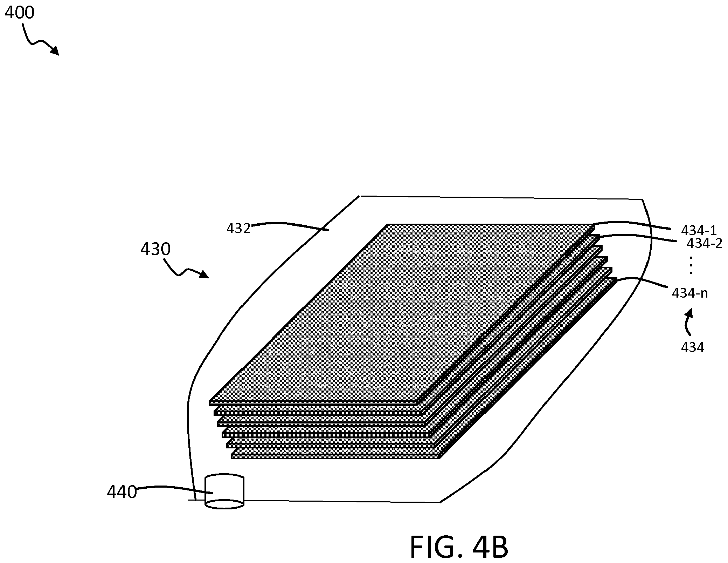

In an embodiment, the sac 130 includes a flexible membrane that is not permeable to air, so that the sac 130 is airtight. The flexible membrane may hold material that may become compacted (e.g., packed) together when air is removed from the sac 130. FIGS. 4A and 4B depict a flexible user interface device 400 having a sac 430 that is an embodiment of the sac 130. The sac 430 includes a flexible membrane 432 and a stack 434 of discrete layers (also referred to simply as a stack of layers) 434-1 through 434-n. The flexible membrane 432 may form an enclosure for holding the stack 434 of layers 434-1 through 434-n. As stated above, the flexible membrane 432 may be made from a flexible and non-stretchable material, such as polypropylene, that is substantially impermeable to air (e.g., oxygen and nitrogen), such that it would take at least hours or days, if not longer, for all or most of any air in the sac 430 to permeate through the flexible membrane 432 and into or out of the sac 430.

In an embodiment, each layer of the stack 434 of layers 434-1 through 434-n may be a woven layer that includes a plurality of interlaced fibers, such as cotton fibers, linen fibers, polyester fibers, or any other fibers. The interlaced fibers in each layer may, e.g., form a mesh network that is permeable to air. In an embodiment, each layer 434-1 through 434-n of the stack 434 may be a sheet of cloth or other fabric. In an embodiment, each layer 434-1 through 434-n may have dimensions that are close to dimensions of a flexible user interface device. For instance, if the user interface device is a rectangular mobile phone or tablet computer, each layer of the stack 434 of layers 434-1 through 434-n may have a length and/or width that is at least 60%, 75%, or 80% of a length or width, respectively, of the mobile phone or tablet computer. For instance, each layer of the stack 434 may have a length that is between 140 mm and 170 mm, and have a width that is between 60 mm and 85 mm. Having such dimensions may allow the sac 430 to more greatly influence an overall stiffness of the flexible user interface device 400 as a whole, rather than influence only a local stiffness of a portion of the flexible user interface device.

In an embodiment, each layer 434-1 through 434-n of the stack 434 may have a thickness that is in a range of 0.09 mm to 5 mm, or 0.5 mm to 5 mm. In an embodiment, the total number of layers in the stack 434 may be in a range of 2 to 15, 15 to 50, 50 to 100, or some other range. In another embodiment, the sac 430 may have only a single woven layer. In an embodiment, an overall thickness of the sac 430, before air has been pumped out of it, may be in a range of 1 mm to 5 mm. When air is pumped out of the sac 430, it may have a substantially rectangular shape or any other shape, depending on how the flexible membrane 432 is formed. In accordance with embodiments hereof, the layers 434-1 through 434-n in the stack 434 may have the same dimensions, or may have different respective dimensions.

In an embodiment, the sac 430 is configured to hold a volume of air, and an air pump 440 attached to the sac 430 may be configured to pump air out of the sac 430 when the pump 440 is activated, and may be controlled to subsequently allow air to be restored into the sac 430. The pump 440 may be powered by an energy storage device 470 (e.g., a lithium battery or a capacitor), and may be controlled by a control unit 450, as illustrated in FIG. 4A. In an embodiment, the pump 440 may be a micro-electrical-mechanical-systems (MEMS) pump that is formed from MEMS components. In an embodiment, the pump 440 may be a rotary vane pump or any other type of pump configured to be able to pump air out of the sac 430. In an embodiment, the pump 440 may be configured to generate a vacuum or near-vacuum level of pressure in the sac 430. In an embodiment, the pump 430 may be configured to decrease air pressure within the sac 430 to 10 inches of mercury (inHg) or lower, or 5 inHg or lower, or to an even lower level. In an embodiment, an airtight connection may be formed between the sac 430 and the pump 440. After air has been pumped out of the sac 430, a valve may prevent air from returning to the sac 430. In an embodiment, the valve may be controllable by the control unit 450. For instance, the control unit 450 may be able to control when the valve prevents air from returning into the sac 430, and when the valve will allow air to be restored into the sac 430.

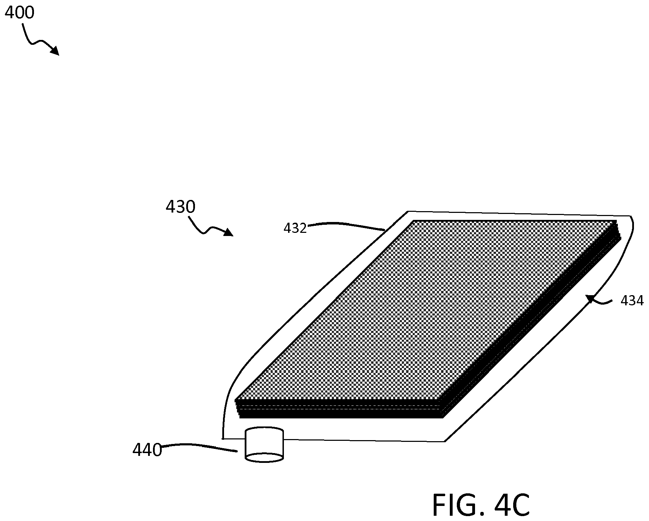

In an embodiment, when there is a baseline amount of air in the sac 430, the sac 430 is flexible, such that it does not interfere with flexing of other deformation of the flexible user interface device 400 to which the sac 430 belongs. For instance, as illustrated in FIG. 4B, when air pressure in the sac 430 is the same as an ambient air pressure around the user interface device 400, e.g., 1 atm, each layer 434-1 through 434-n of the stack 434 may be flexible, and the sac 430 as a whole is flexible, and has no effect or only a small effect on a user's ability to bend or otherwise deform the flexible user interface device 400. As the pump 440 pumps air out of the sac 430, the layers 434-1 through 434-n of the stack 434 may become compressed toward each other, and the flexible membrane 432 may also be pressed against the stack 434, such that these components are jammed or tightly held against each other. This compression may lead to an increased stiffness of the stack 434 and of the sac 430 as a whole. FIG. 4C illustrates a situation in which air has been pumped out of the sac 430 by the pump 440. The sac 430 in FIG. 4C may have an air pressure that is, e.g., ten times lower than that of an ambient air pressure. In an embodiment, the sac 430 in FIG. 4C may have zero air pressure or almost zero air pressure, such that there is a vacuum or near-vacuum within the sac 430. In this situation, the sac 430 may be substantially stiff, such that typical force magnitudes from a user may be unable to bend, flex, or otherwise cause gross deformation of the flexible user interface device 400. In some cases, the user may be able to still bend or otherwise flex the flexible user interface device 400, but may have to exert a force that is, e.g., twice, three, or ten times greater than a force needed to deform the flexible user interface device 400 when the sac 430 had ambient air pressure therein. In an embodiment, when the sac 430 is in the substantially stiff condition depicted in FIG. 4C, it may allow the flexible user interface device 400 to withstand up to 2 N, 5 N, or 10 N of force without undergoing bending, twisting, or other gross deformation.

In an embodiment, the control unit 150/250/350/450 is configured to control a level of stiffness of the sac 130/230/330/430 by controlling the pump 140/240/340/440. For instance, the control unit 150 may be configured to activate the pump 140 in response to determining that an external force is being received at the flexible body 110 of the flexible user interface device 100. The control unit 150 may determine that the external flexing force is received based on, e.g., a measurement signal from the flex sensor 120. More specifically, the control unit 150 may be configured to detect, based on a measurement signal from the flex sensor 120, the flexible body 110 receiving the external flexing force. In some cases, this step may involve determining whether a magnitude of the measurement signal is at least a defined threshold (e.g., a defined voltage threshold).

In an embodiment, in response to detecting that the external flexing force is being received at the flexible body 110, the control unit 150 may be configured to determine whether to generate resistive feedback that resists the external flexing force. For instance, the external flexing force may correspond to a flex gesture, such as a gesture for sequentially browsing through text messages stored on the flexible user interface device 100. Each time the flexible user interface device 100 is bent or otherwise flexed, the flexible user interface device 100 may display a next text message in a sequence of text messages. The control unit 150 may be configured to determine that a detent effect should accompany every time or instance in which the flexible user interface device 100 is bent or otherwise flexed. This determination may be based on, e.g., computer code or other non-transitory computer-readable instructions of an application executing on the flexible user interface device 100, such as a text messaging application. The control unit may determine that, to create the feeling of a detent, resistive feedback will need to be briefly generated to stiffen the flexible user interface device 100.

In some embodiments, resistive feedback may be used to provide information to a user. In one example, the information may be an indication of whether a particular flex gesture is an invalid flex gesture. For instance, a bending gesture or other flex gesture on the flexible user interface device may have no associated application action for an application currently executing on the flexible user interface device 100. When the control unit 150 detects an invalid bending gesture, or more specifically an external bending force associated with the bending gesture, the control unit 150 may determine that resistive feedback is to be generated to provide an indication that there is no valid application action associated with the bending gesture in the application, e.g., texting application, currently executing on the flexible user interface device 100.

In an embodiment, in response to a determination to generate the resistive feedback, the control unit 150 may be configured to cause the sac 130 to increase in stiffness by activating the air pump 140 to pump air out of the sac 130. As a result, material in the sac 130, such as a stack 434 of woven layers 434-1 through 434-n of the embodiment of FIGS. 4A-4C, become substantially unbendable or otherwise undeformable. In an embodiment, the control unit 150 may be configured to control an amount of air that is pumped out of the sac 130, or an air pressure within the sac 130. For instance, the control unit 150 may be configured to determine a magnitude of the external flexing force applied against the flexible body 110, and to cause the air pump 140 to decrease air pressure within the sac 130 to a level that is based on the magnitude of the external flexing force. The magnitude of the external force may be determined, e.g., via the flex sensor 120. The control unit 150 may be configured to control the air pressure within the sac 130 by, e.g., controlling an amount of time that the air pump 140 is activated. In an embodiment, the control unit 150 may be configured to control the air pressure in the sac 130 based on some other value, such as a value in a gaming application or other application.

In an embodiment, the air sac 130 may maintain a low air pressure after the pump 140 has been deactivated. For instance, a valve between the air sac 130 and the air pump 140 may prevent air from re-entering the air sac 130. In some cases, the valve may be controllable by the control unit 150 to open or close, such as via an actuator that opens or closes the valve. In such cases, if the control unit 150 is configured to determine that resistive feedback is to be stopped, it may cause the valve to open so as to allow air to be restored into the air sac 130. Air pressure in the sac 130 may then return to an ambient air pressure in that scenario. In an embodiment, the control unit 150 may be configured to activate the air pump 140 to pump air into the air sac 130, in order to shorten an amount of time for the air pressure in the air sac to return to the ambient air pressure.

In an embodiment, the control unit 150 may be implemented as one or more processors (e.g., microprocessors), a field programmable gate application (FPGA) circuit, a programmable logic array (PLA) circuit, an application specific integrated circuit (ASIC), or any other control circuit. In an embodiment, the functionality of the control unit 150 may be hard-coded into the control unit 150. In an embodiment, the functionality of the control unit 150 may be based on a plurality of non-transitory computer-readable instructions stored in a memory 155 or other storage device. In that embodiment, the control unit 150 may a processor configured to execute such instructions to provide such various functionality. The processor may be a general purpose processor for the flexible user interface device 100, or may be a control unit dedicated to controlling resistive feedback and/or other types of haptic feedback. In this embodiment, as well as in the other embodiments of this application, the memory 155 may be part of the control unit 150, or may be separate from the control unit 150. In an embodiment, the control unit 150 and the energy storage device 170 may together form a signal generator for the air pump 140.

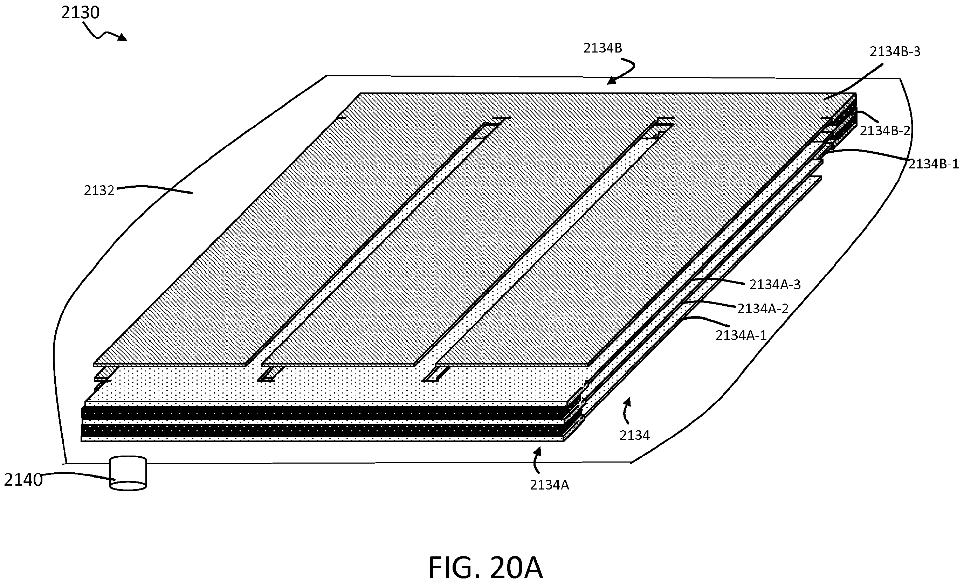

FIG. 20A depicts a sac 2130 that may also be an embodiment of the sac 130. In an embodiment, the sac 2130 may be attached to or embedded within the material of a wearable device, such as a gaming glove. When air is pumped out of the sac 2130, the sac 2130 may resist, e.g., bending of a finger joint within the gaming glove. In an embodiment, the sac 2130 includes a flexible membrane 2132 and a stack 2134 of layers 2134A-1, 2134A-2, 2134A-3, 2134B-1, 2134B-2, 2134B-3. The flexible membrane 2132 may form an enclosure for holding the stack 2134 of layers. Like the flexible membrane 2132, the flexible membrane 2134 may be formed from a flexible and non-stretchable material that is substantially impermeable to air. In an embodiment, the flexible membrane 2132 may have dimensions of 45 mm x 65 mm. In an embodiment, a silicone sheet may enclose the air sac 2130.

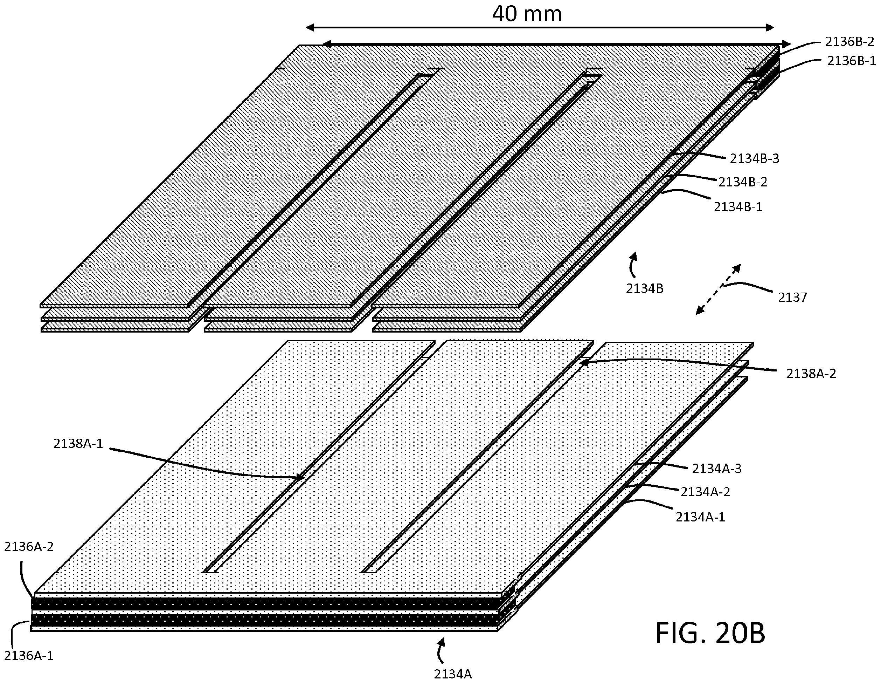

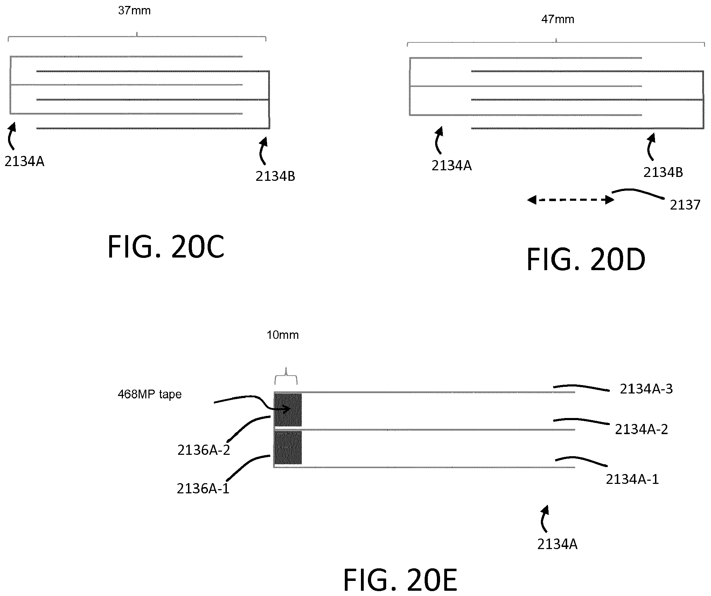

In an embodiment, the stack 2134 may comprise a first stack 2134A and a second stack 2134B. As depicted in FIG. 20B, the stack 2134A may include a plurality of layers 2134A-1, 2134A-2, and 2134A-3 that are bonded or otherwise attached to each other via, e.g., a first layer 2136A-1 of adhesive and a second layer 2136A-2 of adhesive, such as 10-mm wide strip of 3M® 468MP tape, as depicted in FIG. 20E. Similarly, the stack 2134B may include a plurality of layers 2134B-1, 2134B-2, and 2134B-3 that are attached to each other via, e.g., a first layer 2136B-1 of adhesive and a second layer 2136B-2 of adhesive. As illustrated in FIG. 20A, 20C, and 20D, the layers of the stack 2134A may be interleaved with the layers of the stack 2134B, such that one or more layers of the stack 2134A can directly contact two layers of the stack 2134B, and such that one or more layers of the stack 2134B can directly contact two layers of the stack 2134A. In an embodiment, each layer of the stack 2134A and stack 2134B may have one or more cuts, such as cut 2138A-1 and cut 2138A-2. The one or more cuts may divide each layer of the stacks 2134A, 2134B into a plurality of strips.

In an embodiment, the sac 2130 may be attached to an air pump 2140 that is configured to pump air out of the sac 2130. In an embodiment, the air pump 2140 may be able to reduce air pressure within the sac 2130 to, e.g., 5 inHg, 14 inHg, or some other value. In an embodiment, the air pump 2140 may be able to reach a target air pressure in a time that is less than 1 second (e.g., 200 msec). In an embodiment, the air pump 2140 may be implemented with the micro pump 3A120CNSN, and may be able to achieve a minimum free flow of 820 cc/minute, and a minimum vacuum at dead head of 12.3 inHg (415 mbar). In some cases, the air pump 2130 may be the same as the pump 440.

In an embodiment, when there is air in the sac 2130, the layers of stack 2134A may be able to slide relative to the layers of stack 2134B along an sliding axis 2137. For instance, FIGS. 20C and 20D depict the layers of the stack 2134A and the layers of the stack 2134B sliding by 10 mm relative to each other (from an overall length of 37 mm to an overall length of 47 mm). When air is pumped out of the sac 2130, such as to a near-vacuum level, the layers of the stack 2134A and stack 2134B may be jammed against each other, which may increase friction between them significantly. The increase in friction may prevent the layers of the two stacks 2134A, 2134B from sliding relative to each other.

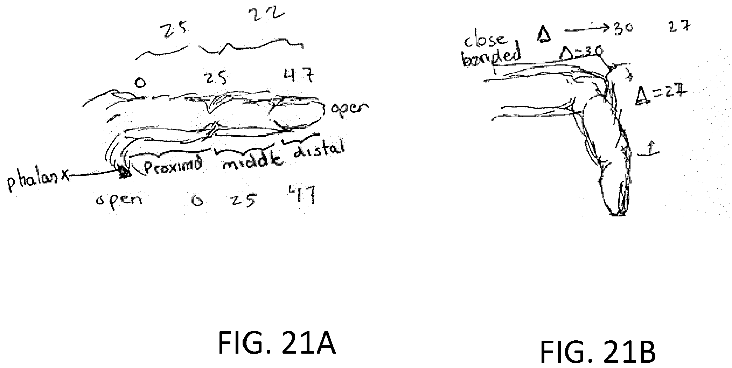

As stated above, the sac 2130 may be attached to or embedded within a glove, such as a gaming glove. In an embodiment, sac 2130 may be oriented so that the sliding axis 2137 is parallel to the fingers covers of the glove. In an embodiment, at least one of the stacks 2134A, 2134B may extend along all or a substantial portion of at least one finger cover of the glove (e.g., along each finger cover of the glove). As depicted in FIGS. 21A and 21B, when a user's finger bends within the glove, a corresponding finger cover that surrounds the finger may have to extend in length, such as from 37 mm to 47 mm. In an embodiment, layer jamming may be used to restrict bending of the finger within the glove. More specifically, the sac 2130 may be attached to the finger covers of the glove, such that when the user's finger bends, the layers of the stack 2134A, 2134B slide relative to each other along the sliding axis 2137 in order to allow the finger cover to extend in length. When air is pumped out of the sac 2130, however, the layers of the stack 2134A, 2134B may be prevented or otherwise constrained in their ability to slide relative to each other. As a result, one or more finger covers of the glove may be unable or limited in its ability to extend in length, which in turn may prevent or limit the ability of a finger in the finger cover to bend. Thus, the air sac 2130 may function as a locking mechanism that resists bending of a finger within a glove. In an embodiment, the air sac 2130 may be able to resist at least 10 N of external bending force.

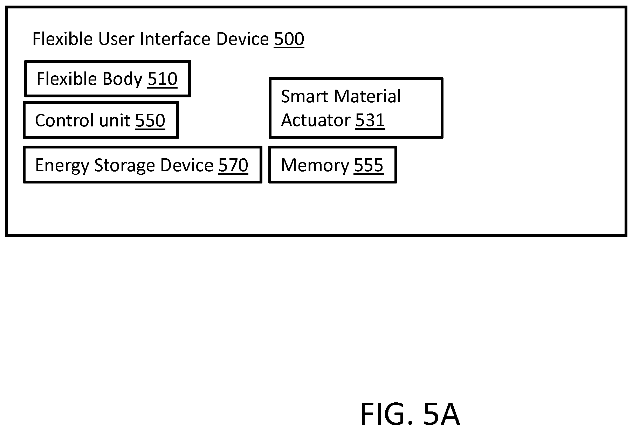

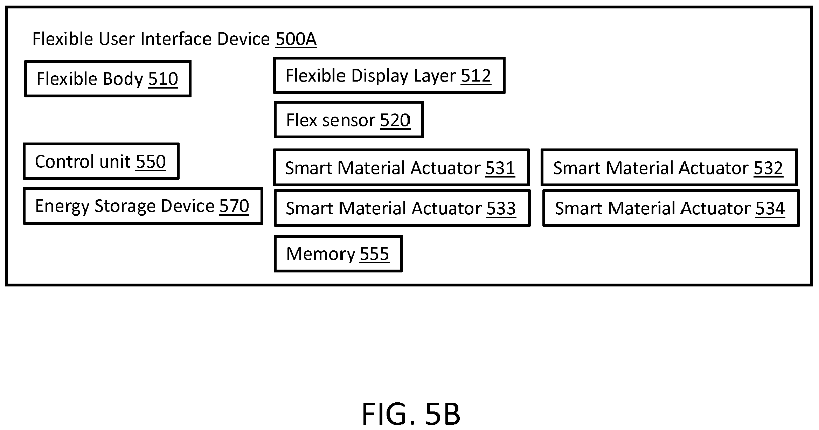

As discussed above, one aspect of the embodiments herein relates to providing resistive feedback via a smart material actuator, such as a macrofiber composite (MFC) actuator. FIG. 5A provides a block diagram of a flexible user interface device 500 that is configured to generate resistive feedback via such an actuator. More specifically, flexible display device 500 includes a flexible body 510, at least one smart material actuator 531 disposed on the flexible body 510, a control unit 550, a memory 555, and an energy storage device 570. In an embodiment, the flexible user interface device 500 may be a display device. For instance, FIG. 5B depicts a flexible user interface device 500A that is a more specific embodiment of the flexible user interface device 500. The flexible user interface device 500A may include the same components as illustrated in FIG. 5A, but further include a flexible display layer 512, such as a LCD layer or an OLED layer, additional actuators 532-534, and a flex sensor 520. The flex sensor 520 may be, e.g., a strain gauge, that is configured to detect an external force being received at the flexible body 510. The flex sensor 520 may be separate from the actuators 531-534. In another embodiment, the flexible user interface device 500 may have no display layer and no display functionality, and/or have no separate flex sensor. In such an embodiment, the flexible user interface device 500 may use at least the smart material actuator 531 to detect the external flexing force on the flexible body. As discussed above with respect to other embodiments, the flexible user interface device 500 may be a mobile phone, a tablet computer, a remote control device, an e-reader, a wearable device, or any other user interface device.

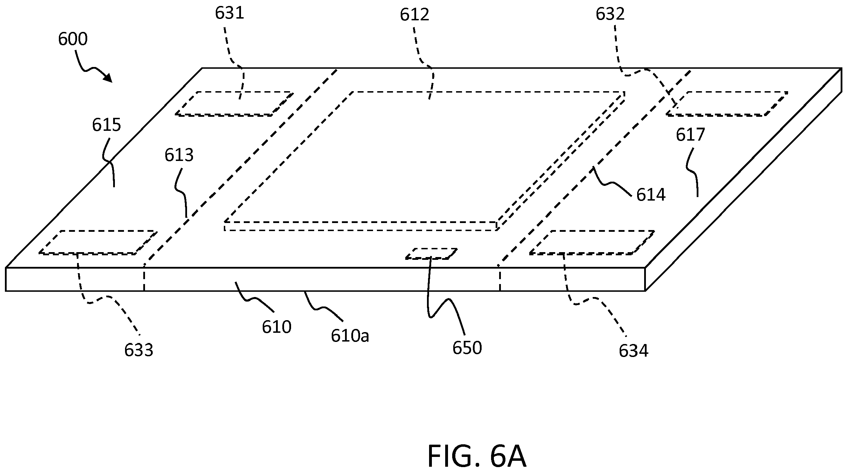

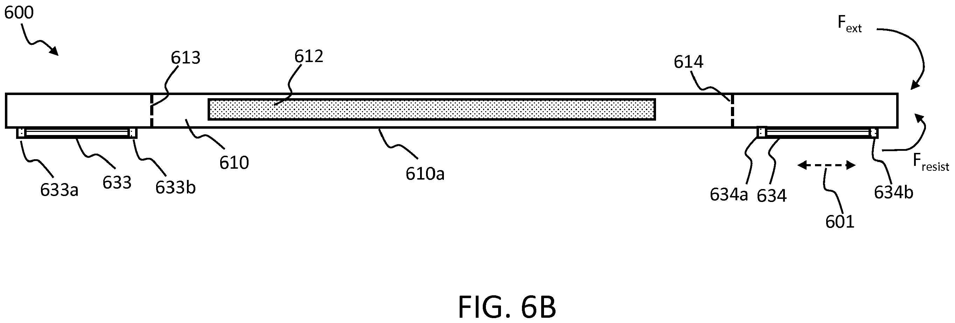

FIGS. 6A and 6B depict a flexible user interface device 600 that is a more specific embodiment of the flexible user interface device 500. The flexible user interface device 600 may include a flexible body 610 that includes a flexible substrate, though in another embodiment the flexible body 610 may include a flexible shell, or any other type of flexible body, such as a combination of a flexible shell and a flexible substrate. The flexible user interface device 600 may further include a flexible display layer 612 embedded in or otherwise disposed within the flexible substrate of the flexible body 610.

In an embodiment, the flexible body 610 may have one or more creases 613, 614. The one or more creases 613, 614 may facilitate bending or other deformation of the flexible body 610. For instance, crease 614 may be formed as a living hinge that facilitates bending of an edge portion 617 of the flexible body 610 about the living hinge, toward a middle portion of the flexible body 610. Similarly, the crease 613 may act as a living hinge that facilitates bending of an opposite edge portion 615 of the flexible body 610 about the hinge, also toward the middle portion of the flexible body 610. In some cases, the crease 613 or 614 may allow a portion of the flexible body 610 to be bent close to 180° about the crease 613 or 614, in which case the bending may be referred to as folding of the portion of the flexible body 610. In an embodiment, the one or more creases 613, 614 may be living hinges, such as thinned sections, created during formation of the flexible body 610, either during manufacturing or during use by a user. In an embodiment, the one or more creases 613, 614 may be formed by a stamping operation. In an embodiment, each crease of the one or more creases 613, 614 may form a shallow furrow or a ridge. For instance, each of crease 613 or 614 may form a shallow furrow on a first outer surface of the flexible body 610, and form a ridge on a second outer surface of the flexible body 610.

In an embodiment, the flexible user interface device 600 includes actuators 631, 632, 633, 634 disposed on an outer surface 610a of the flexible body 610, and a control unit 650 in communication with each of the plurality of actuators 631-634. Each actuator of the plurality of actuators 631-634 may, e.g., be bonded to the outer surface 610a of the flexible substrate. In some instances, each of the plurality of actuators 631-634 may form a unimorph structure with the flexible substrate of the flexible body 610. Further, each actuator of the plurality of actuators 631-634 may have a layer of actuatable material and two electrodes disposed on opposite ends of the layer of actuatable material. The actuatable material may generate a stretching force or a contracting force along a plane of the actuatable material, e.g., along a length or width of the actuatable material, when a voltage difference is generated between the opposite ends of the actuatable material via the two electrodes. For instance, FIG. 6B depicts the actuator 633 and the actuator 634, each of which may have a layer of actuatable material. FIG. 6B further depicts two electrodes 633a, 633b disposed on opposite ends of the layer of actuatable material of actuator 633, and two electrodes 634a, 634b disposed on opposite ends of the layer of actuatable material of actuator 634. The electrodes 633a, 633b may be aligned along a length or width of the layer of actuatable material of actuator 633, and the electrodes 634a, 634b may be aligned along a length or width of the layer of actuatable material of the actuator 634. As illustrated in FIG. 6B, when a voltage difference is generated between, e.g., electrodes 634a and 634b, the actuatable material of the actuator 634 may generate a stretching force that is along axis 601. If the voltage difference is reversed in polarity, the actuatable material may generate a contracting force along the same axis. As discussed in more detail below, the stretching force may be converted to a force Fᵣₑₛᵢₛₜ that resists the external force Fₑₓₜ from a user

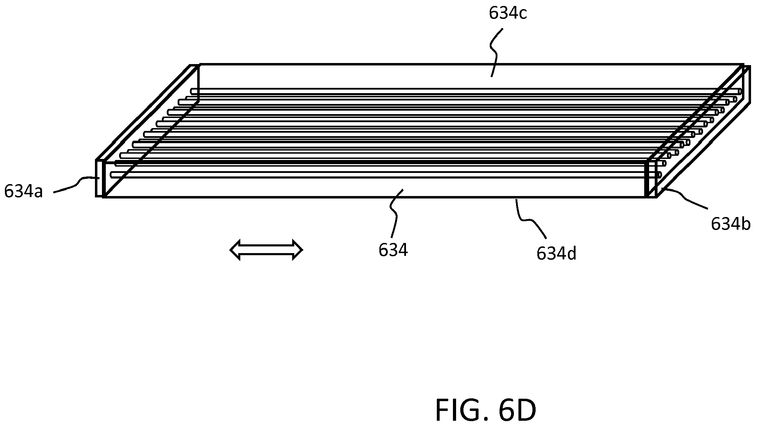

In an embodiment, the layer of actuatable material of one or more of the plurality of actuators 631-634 may be a layer of piezoelectric material configured to generate a stretching force or contracting force along a length or width of the layer when a voltage difference is generated between opposite ends of the piezoelectric material. In some cases, the piezoelectric material may be a macrofiber composite (MFC) material. The MFC material may include a plurality of piezoelectric fibers embedded in a polymer matrix, such as an adhesive. Such a situation is illustrated in FIG. 6D, in which the layer of material is a MFC material, and the actuator 634 is a MFC actuator. FIG. 6D further depicts the electrodes 634a and 634b that are disposed on opposite ends of the actuator 634, wherein a voltage difference between the electrodes 634a, 634b may cause the layer of MFC material to stretch in the direction of the arrows shown in the figure.

FIG. 6D further identifies a first surface 634c of the actuator 634, and a second, opposite surface 634d of the actuator 634. In an embodiment, when the actuator 634 is bonded to the flexible body 610, the first surface 634c of the actuator 634 may be in direct contact with the surface 610a of the flexible body 610.

In an embodiment, the actuator 634, as well as the other actuators 631-633, may be configured to exert a bending force or other flexing force on the flexible body 610 that resists an external bending force from a user. The bending force may be converted from or otherwise arise from the stretching force generated by the actuatable material of the actuator 634. More specifically, the actuator 634 may be bonded to the flexible body 610 via its surface 634c, as discussed above, such that there is bonding between the surface 634c of the layer of actuatable material of the actuator 634 and the flexible substrate of the flexible body 610. In an embodiment, the flexible body 610 may be bendable, but may be much less stretchable along the axis 601, and/or much less able to contract along the axis 601 relative to the actuatable material of the actuator 634, wherein the axis 601 may be an axis that is aligned along a length or width of the layer of actuatable material. In such a situation, the flexible body 610 may prevent or limit stretching and/or contraction of the layer of actuatable material along axis 601 at the first surface 634c thereof, because the first surface 634c is bonded to the flexible body 610. In other words, the layer of actuatable material of the actuator 634 may be unable to stretch along the length or width of the layer at the first surface 634c, or may do so at a smaller magnitude relative to the stretching of the actuatable material at the second surface 634d. Similarly, the bonding may prevent the layer of actuatable material of the actuator 634 from contracting along the length or width of the layer at the first surface 634c, or may cause any contraction to have a smaller magnitude relative to contraction of the actuatable material at the second surface 634d. This difference between the respective amounts of stretching or contraction on two opposite sides of the layer of actuatable material of the actuator 634 may convert the stretching force or the contracting force, which is along the axis 601 in FIG. 6B, into a bending force, such as the bending force Fᵣₑₛᵢₛₜ in FIG. 6B that resists the external force Fₑₓₜ. In an embodiment, the bending force or other flexing force generated by the actuator 634, or by any other of the actuators 631-633, may increase a level of stiffness of the flexible user interface device 600.

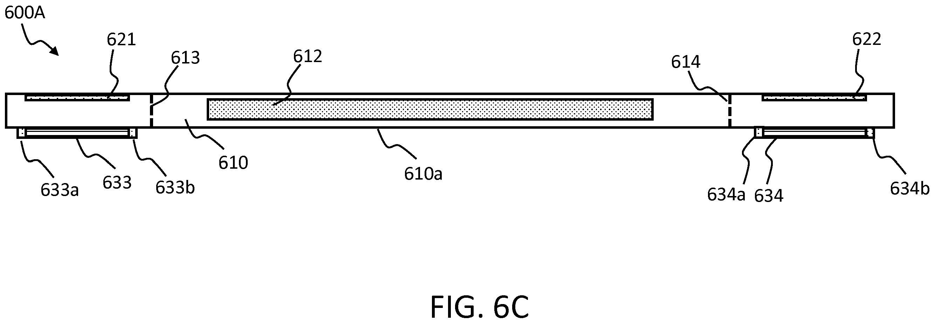

In an embodiment, the control unit 650 of the flexible user interface device 600 may be configured to detect the flexible body 610 receiving a first flexing force that is an external flexing force. In some cases, the flexible user interface device 600 may have a flex sensor separate from the actuators 631-634. For instance, FIG. 6C illustrates a flexible user interface device 600A that is an embodiment of the flexible user interface device 600. The flexible user interface device 600A includes all of the components of FIG. 6A and 6B, and further includes a flex sensor 621 and a flex sensor 622 embedded in the flexible body 610. The control unit 650 may be configured to perform the detection of the external force based on a measurement signal from the flex sensor 621 or 622. In some cases, the control unit 650 may be configured to detect the external flexing force by using the plurality of actuators 631-634, and the flexible user interface device 600 may have no separate flex sensor. In such cases, the plurality of actuators 631-634 may further be transducers that are configured to convert a mechanical input to an electrical output. For instance, before the actuatable materials of the plurality of actuators 631-634 are activated to generate the resistive feedback, they may first be used to detect the external flexing force Fₑₓₜ of FIG. 6B. As the external flexing force Fₑₓₜ begins to deform the flexible body 610 by a small amount, the actuatable material may generate an electrical signal, which may be an output signal. The control unit 650 may use an output electrical signal from the flex sensors 621, 622 or the plurality of actuators 631-634 as a measurement signal to detect the external flexing force Fₑₓₜ. For instance, as the external flexing force F begins to deform the flexible body 610 by a small amount, the measurement signal from the actuator 634 or the flex sensor 622 may rise in magnitude and reach a defined threshold value within, e.g., 10 msec after a beginning of the external flexing force Fₑₓₜ. The plurality of actuators 631-634 may be activated thereafter to resist further deformation of the flexible body 610, as discussed below.

In an embodiment, in response to detecting the external flexing force being received at the flexible body 610, the control unit 650 may be configured to determine whether to generate resistive feedback that resists the external flexing force. In response to a determination to generate the resistive feedback, the control unit may be configured to activate one or more of the plurality of actuators 631-634 by applying driving signals to the electrodes of each actuator of the one or more actuators 631-634. In an embodiment, the control unit 650 may come with an energy storage device to form a signal generator for generating the driving signals. The driving signals may generate, for each actuator of the one or more actuators, a voltage difference between opposite ends of the actuatable material of the actuator via the electrodes of the actuator, such as actuator 634. The voltage difference causes the layer of actuatable material to exert a second flexing force Fᵣₑₛᵢₛₜ that resists the external flexing force, as discussed above.

In an embodiment, the plurality of actuators 631-634 may be used to generate only resistive feedback, or may also be used to generate active haptic effects/active haptic feedback at various times. The active haptic effects may be designed to actively create deformation or other movement in the flexible body 610 of the flexible user interface device 600. For instance, the active haptic effects may generate a force to bend the flexible body 610 while the user interface device 600 is in a user's pocket, or while the user interface device 600 is resting on a user's hand. The resistive feedback may be designed to resist deformation that a user is attempting to apply, and may be generated only in response to an external force from a user. Further, the resistive feedback may generate a force that is opposite in direction and less than or equal in magnitude to the external force. In some cases, the magnitude of the force from the resistive feedback may be controlled to be proportional to a magnitude of the external force. For instance, the control unit 650 may be configured to cause a voltage difference between opposite ends of the actuatable material of one or more of the plurality of actuators 631-634 to have a magnitude that is proportional to or otherwise based on a magnitude of the external flexing force Fₑₓₜ being applied to the flexible body 610. Limiting the plurality of actuators 631-634 to only resistive feedback may save power. Thus, in some instances, the flexible user interface device 600 may be configured to limit its use of the plurality of actuators 631-634 to only resistive feedback when a battery level is less than a defined threshold.

In an embodiment, one or more of the plurality of actuators 631-634 may have actuatable material that is different than piezoelectric material. For instance, the one or more actuators may include an electroactive polymer (EAP), such as polyvinylidene fluoride (PVDF), a shape memory polymer (SMP) material, a shape memory alloy (SMA) material, or any other actuatable material.

As illustrated in FIGS. 6A and 6B, each of the actuators 631-634 may be disposed between one of the creases 613, 614 and a respective edge of the flexible substrate of the flexible body 610. In an embodiment, there is no overlap between the plurality of actuators 631-634 and each of the creases 613, 614.

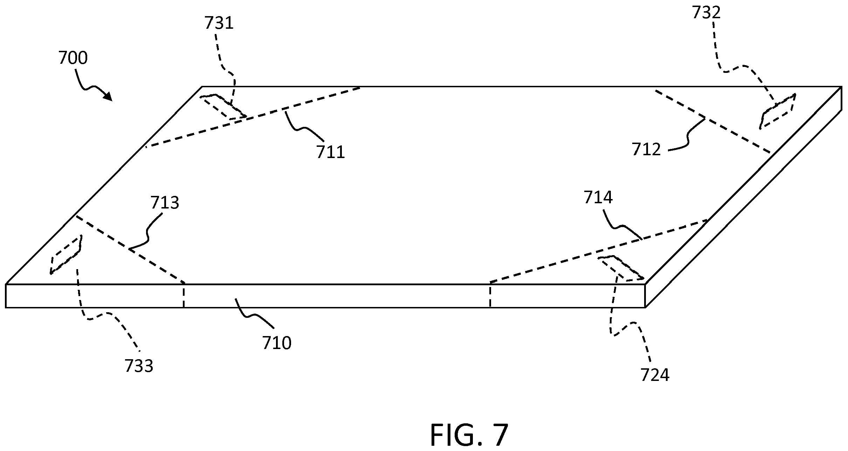

In an embodiment, as depicted in FIG. 7, a flexible user interface device 700 may have actuators that are each disposed between a crease and a corner thereof. More specifically, FIG. 7 illustrates a flexible user interface device 700 having a flexible body 710 and diagonal creases that are between a central portion of the flexible body 710 and respective corners thereof. The flexible user interface device 700 further includes actuators 731, 732, 733, 734 that are located between respective creases and respective corners of the flexible body 710. Each of the actuators 731, 732, 733, 734 may have a layer of actuatable material, such as a layer of MFC material, that is configured to generate a stretching force or contracting force when a voltage difference is generated across two ends of the layer. When an external force is applied to one or more corners of the flexible body 710, respective feedback may be provided at the one or more corners via respective ones of the actuators 731, 732, 733, 734.

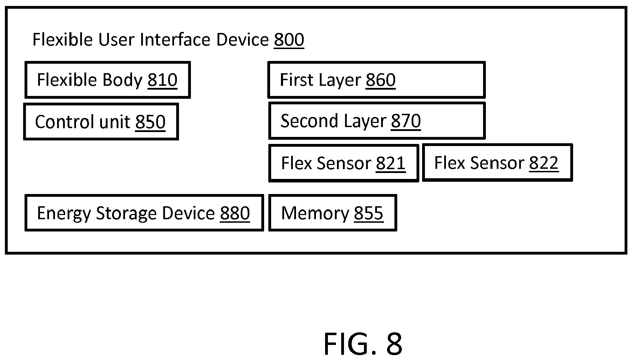

As discussed above, some embodiments in accordance herewith may provide resistive feedback based on generating electrostatic or electromagnetic adhesion between a stack having at least two layers. FIG. 8 depicts a flexible user interface device 800 that has a stack with at least a first layer 860 and a second layer 870, and is configured to provide resistive feedback by generating adhesion between the first layer 860 and the second layer 870. The flexible user interface device 800 further includes a flexible body 810 within or on which the first layer 860 and second layer 870 are disposed, and includes a control unit 850, a memory 855, one or more flex sensors 821, 822, and an energy storage device 880. In an embodiment, the flexible user interface device 800 may have a stack with more than just layers 860, 870. For instance, the stack may have, e.g., 10 layers, 20 layers, or 100 layers. The stack may have a thickness that is in a range of 0.1 mm to 1 mm, 1 mm to 5 mm, or in some other range. In an embodiment, the flexible user interface device 800 may further include a flexible display layer, so as to become a flexible display device.

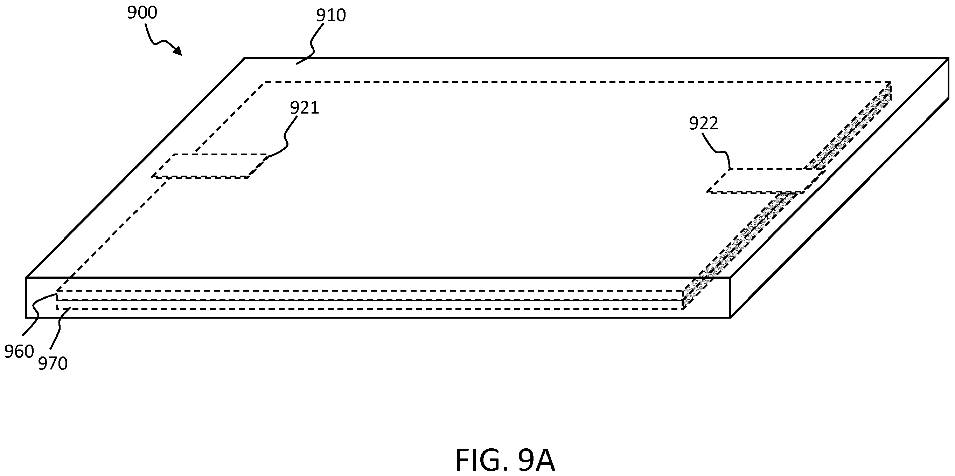

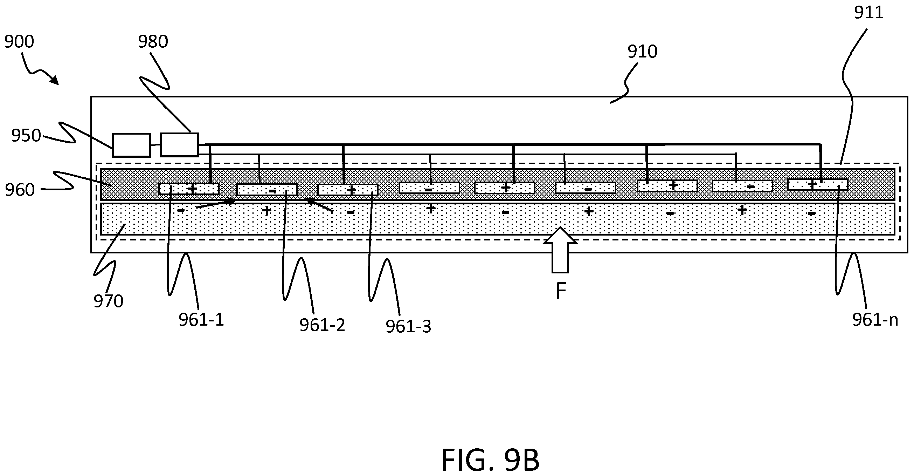

FIGS. 9A and 9B depict a flexible user interface device 900 that is an embodiment of the flexible user interface device 800 for providing resistive feedback based on generating electrostatic adhesion between a stack having at least two layers. The flexible user interface device 900 includes a flexible body 910, flex sensors 921, 922 disposed at or near opposite edges of the flexible body 910, a control unit 950, an energy storage device 980 such as a battery, and a stack made of at least layer 960 and layer 970. In an embodiment, the flexible body 910 may be formed from a flexible substrate, and/or from a flexible shell. In an embodiment, the flexible body 910 may form a compartment 911, cavity, or other space in which the stack of layers 960, 970 are disposed, as depicted in FIG. 9B. In another embodiment, the stack of layers 960, 960 may be bonded to the flexible body 910.

In FIG. 9B, a plurality of electrodes 916-1 to 916-n may be embedded or otherwise disposed within layer 960. In another embodiment, the electrodes 916-1 to 916-n may be disposed on an outer surface of layer 960. In an embodiment, layer 960 and layer 970 may each be formed from a flexible electrically insulative material, such as polyimide. In some cases, the layer 970 may consist essentially of the electrically insulative material. The layers 960, 970 may have dimensions that are in a range of, e.g., 5 cm to 10 cm, 10 cm to 20 cm, or some other range. In an embodiment, each of layers 960, 970 has a thickness that is in a range of 50 micron to 1 mm. In some cases, the flexible electrically insulative material may have good dielectric properties that can withstand a voltage level of at least 100 V, 500 V, or 1 kV. In an embodiment, the layers 960, 970 may be configured to be able to freely slide relative to each other when no electrical charge is being applied to the electrodes 916-1 through 916-n, and the flexible body 910 is being flexed.

In an embodiment, each of the electrodes 916-1 through 916-n may be switchably connected to the energy storage device 980. The energy storage device 980 may be controlled by the control unit 950 to provide a positive voltage or a negative voltage to the electrodes 916-1 to 916-n, which may provide a positive charge or a negative charge, respectively, to the electrodes 916-1 to 916-n. In an embodiment, the control unit 950 and the energy storage device 980 may form a signal generator. The voltage may be in a range of, e.g., 100 V to 1 kV. The voltage may cause the layers 960, 970 to engage each other, or to increase a level of engagement with each other. The increased level of engagement may be reflected in a greater amount of contact surface area between the layers 960, 970, or an increased amount of force that attracts, by pulling or pushing, the layers 960, 970 toward each other. The increased level of engagement may thus increase a level of friction between the two layers 960, 970, which may prevent or otherwise limit the ability of the two layers 960, 970 to slide relative to each other.

More specifically, when electric charge is provided to the electrodes 916-1 to 916-n of layer 960, the electric charge may induce an opposite charge at a surface of layer 970. The opposite charges may cause electrostatic attraction between layers 960 and 970, which in turn creates a force F that draws layer 970 toward layer 960, or vice versa. The force may depend on dimensions of the layers 960, 970. As an example, the layers 960, 970 may each have dimensions of 10 cm x 18 cm, and the electrostatic attraction may generate a force of 1.5 N to draw layer 970 toward layer 960. As stated above, the increased amount of attraction between the two layers 960, 970 may increase friction, such as static friction, between the two layers 960, 970. In the example above, the increased amount of static friction may resist shear forces of up to 0.6 N before the two layers 960, 970 will slide relative to each other. When no charge is applied to the electrodes in FIG. 9B, the two layers 960 may still be in contact, but the contact surface area may be low, and the resulting friction may be low.

In FIG. 9B, successive electrodes, such as electrodes 916-1 and 916-2, or electrodes 916-2 and 916-3, may be provided with respective opposite electrical charges by the energy storage device 980. Such an arrangement may further limit the ability of the layers 960, 970 to slide relative to each other, because of the charges that are induced in layer 970. For instance, FIG. 9B illustrates electrode 916-1 inducing a negative charge in a region of layer 970 immediately facing electrode 916-1. Similarly, electrode 916-3 induces a negative charge in a region of layer 970 immediately facing electrode 916-3. The induced negative charges in layer 970 may both repel the negative charge on electrode 916-2 in layer 960. The repelling force may further resist sliding movement of the layer 960 relative to layer 970. In another embodiment, all of the electrodes of electrodes 916-1 to 916-n may be provided with the same electrical charge.

In an embodiment, flexible user interface device 900 may have a stack with multiple pairs, e.g., 25 pairs, of layers, wherein each of the pairs has a respective first layer with the same structure as layer 960, and a respective second layer with the same structure as layer 970. In another embodiment, the layer 970 may be made of an electrically conductive material instead of an electrically insulative material. For instance, the layer 970 in the alternative embodiment may consist essentially of a single electrode.

In an embodiment, the control unit 950 may control when to apply electrical charge to the electrodes 916-1 to 916-n. For instance, the control unit 950 may be configured to detect, based on a measurement signal from flex sensor 921 and/or 922, whether an external flexing force is being received at the flexible body 910. In response to detecting the flexing force, the control unit may determine whether to generate resistive feedback that resists the external flexing force. Further, in response to a determination to generate the resistive feedback, the control unit 950 may be configured to generate electrostatic adhesion between layers 960, 970 by causing the energy storage device 980 to provide electrical charge, or more generally an electrical driving signal, to the electrodes 916-1 to 916-n. The electrostatic adhesion between the layers 960, 970 may prevent them from sliding relative to each other. In one example, when the electrodes in FIG. 9B are activated with a voltage of, e.g., 100 V to 1 kV, they may generate an amount of friction that resists shear force in a range of, e.g., 0.03 N to 1 N. In an embodiment, the control unit 950 may control an electrical signal that is provided from the energy storage device 980 to the electrodes 916-1 to 916-n. The electrical signal may be a direct current (DC) signal or an alternating current (AC) signal, such as a sinusoidal voltage signal with an amplitude of 1500 V. The frequency of such a sinusoidal signal may be in a range of, e.g., 2 Hz to 300 Hz. Such a vibration may create or simulate spatial detents as the two layers 960, 970 slide relative to each other.

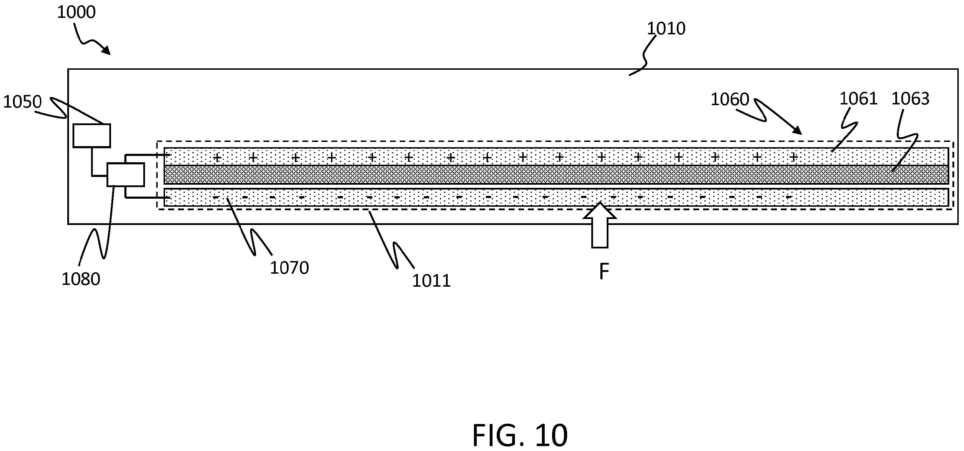

FIG. 10 depicts a flexible user interface device 1000 that is an embodiment of the flexible user interface device 800 for providing resistive feedback based on generating electrostatic adhesion between a stack having at least two layers. The flexible user interface device 1000 includes a flexible body 1010, a stack that includes at least layers 1060, 1070, a control unit 1050, and an energy storage device 1080. The layers 1060, 1070 may be disposed in a compartment 1011 or other space formed within the flexible body 1010, and may be free to slide relative to each other when electroadhesion is not being generated.

In an embodiment, the layer 1060 may include electrically insulating material and a first electrode bonded to the electrically insulating material. More specifically, the layer 1060 in FIG. 10 may be made from only a single electrode 1061 and a single electrically insulative layer 1063 that are permanently bonded to each other via a chemical adhesive or other form of bonding. In another embodiment, the electrode 1061 may be embedded in the insulative layer 1063. The electrode 1061 may be the only electrode included in the layer 1060, and may have an area equal to or substantially equal to an area of the layer 1060. The electrically insulative layer 1063 may include, e.g., a dielectric elastomer, or some other material. In an embodiment, the layer 1070 includes an additional single electrode that is embedded in or forms the layer 1070, as illustrated in FIG. 10. For instance, the layer 1070 may consist essentially of the additional electrode.

In an embodiment, the energy storage unit 1080 may be configured to place two opposite charges, or more generally two signals that are opposite in polarity, on the electrode 1061 of the layer 1060 and on the electrode of layer 1070, respectively. The opposite electric charge may cause electrostatic attraction between layers 1060, 1070, which may draw the layers 1060, 1070 toward each other. In an embodiment, a control unit may detect the flexible body 1010 receiving an external flexing force and may determine that resistive feedback is to be generated. In response to determining that the resistive feedback is to be generated, the control unit may apply a first charge on the electrode 1061, and apply a second and opposite charge on the electrode formed by layer 1070, so as to prevent the layers 1060, 1070 from sliding relative to each other.

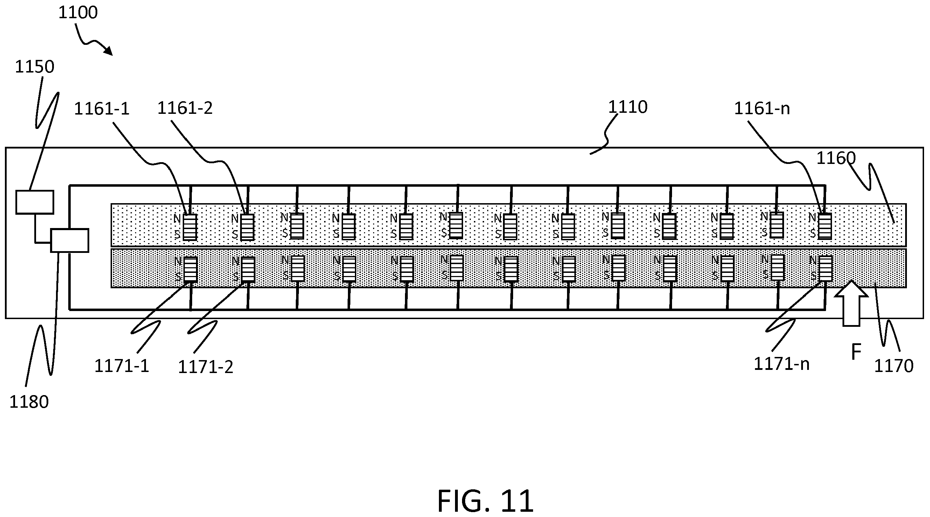

FIG. 11 depicts a flexible user interface device 1100 that uses electromagnets to generate electromagnetic adhesion. The flexible user interface device 1100 may be an embodiment of the flexible user interface device 800, and may include a flexible body 1110, a control unit 1150, an energy storage device 1180, and a stack of at least layers 1160, 1170. The stack of layers may include a first set of electromagnets 1161-1 to 1161-n embedded in or bonded to layer 1160, and include a second set of electromagnets 1171 to 1171-n embedded in or bonded to layer 1170. In another embodiment, each of the layers 1160, 1170 may include only a single electromagnet instead of a plurality of electromagnets.

In an embodiment, each of the electromagnets may include an electrical trace that is printed or otherwise formed into a shape of a coil (i.e., a printed coil). In an embodiment, all or a portion of the layer 1160 may be made of flexible steel, which may enhance a magnetic field generated by the electromagnets 1161-1 to 1161-n.

In an embodiment, the control unit 1150 may be configured to control the electromagnets in FIG. 11. For instance, in response to a determination to generate resistive feedback, the control unit may be configured to cause the first set of electromagnets 1161-1 to 1161-n to generate respective magnetic fields with a first magnetic polarity, and to cause the second set of electromagnets 1171-1 to 1171-n to generate respective second magnetic fields with a second and opposite magnetic polarity, as depicted in FIG. 11. The opposite magnetic polarities may create electromagnetic attraction between the first set of electromagnets 1161-1 to 1161-n and the second set of electromagnets 1171-1 to 1171-n, which may in turn create attraction between layer 1160 and 1170. The attractive force between the layers 1160, 1170 may increase the friction therebetween, which may increase a level of stiffness for the stack of layers 1160, 1170.

In an embodiment, the first set of electromagnets 1161-1 to 1161-n may be aligned with respective ones of the second set of electromagnets 1171-1 to 1171-n. The first set of electromagnets 1161-1 to 1161-n may have magnetic fields with the same polarity, and the second set of electromagnets 1171-1 to 1171-n may have magnetic fields with the same polarity, as illustrated in FIG. 11. In another embodiment, the first set of electromagnets 1161-1 to 1161-n may alternate in magnetic polarity, such that consecutive electromagnets thereof have opposite magnetic polarities. Similarly, the second set of electromagnets 1171-1 to 1171-n may alternate in magnetic polarity, such that consecutive electromagnets thereof have opposite magnetic polarities. In this alternate embodiment, each pair of aligned electromagnets from the respective first set and second set of electromagnets, such as the pair of electromagnets 1161-1 and 1171-1, may have magnetic fields that are opposite in polarity. While FIG. 11 involves a first set of electromagnets 1161-1 to 1161-n and a second set of electromagnets 1171-1 to 1171-n, another embodiment may replace one of the sets of electromagnets with a set of permanent magnets.

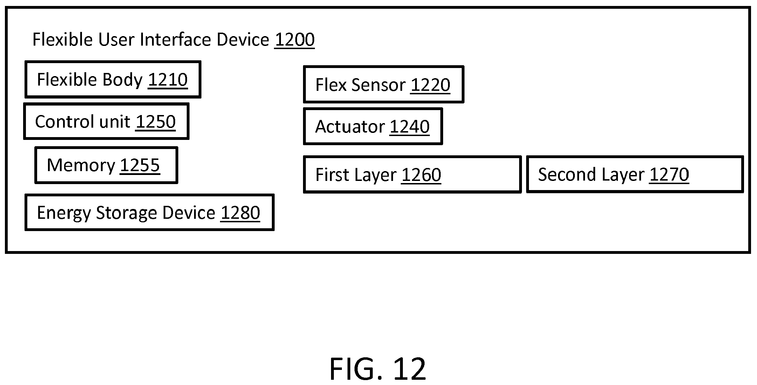

As discussed above, friction between two layers may be increased by forming an array of micro-wedges on a surface of one of the layers. When the two layers are pressed against each other or otherwise engaged, the micro-wedges on one layer may deform so as to expose more surface area with which to contact the other layer. The increased contact surface area increases a total amount of friction between the two layers. The array of micro-wedges may mimic behavior of setae on a gecko's foot, which may be able to generate a large amount of friction between the gecko's foot and a surface against which the foot is pressed. FIG. 12 illustrates a flexible user interface device 1200 that may use such an array of micro-wedges formed from, e.g., silicone. More specifically, the flexible user interface device 1200 includes a flexible body 1210, a control unit 1250, a memory 1255, an energy storage device 1280, a flex sensor 1220, a first layer 1260, a second layer 1270, and an actuator 1240.

In an embodiment, the first layer 1260 may have an array of micro-wedges formed or otherwise disposed on a surface of the first layer 1260. In an embodiment, the micro-wedges may be divided into multiple patches, wherein each patch has a sub-array of micro-wedges. In an embodiment, the actuator 1240 may be configured to engage the first layer 1260 and the second layer 1270, or increase a level of engagement between the two layers 1260, 1270 by pressing or pulling layer 1260 toward layer 1270, or vice versa. When the two layers 1260, 1270 are not engaged or have only a baseline level of engagement, they may be able to freely slide relative to each other when an external flexing force is applied to the flexible body 1210. If the two layers 1260, 1270 are not engaged during this process, the micro-wedges on the first layer 1260 may be not in contact with the second layer 1270. If they have a baseline level of engagement, the micro-wedges on the first layer 1260 may only graze or otherwise barely contact the second layer 1270. The actuator 1240 may be configured, when activated, to press the first layer 1260 against the second layer 1270, or vice versa, so as to increase contact between the micro-wedges on the first layer 1260 with a surface of the second layer 1270. When the actuator 1240 is deactivated, the first layer 1260 and the second layer 1270 may naturally disengage via, e.g., gravity or a bias spring force between them.

In an embodiment, the control unit 1250 may be configured to activate the actuator 1240 based on a measurement signal from the flex sensor 1220. For instance, the control unit 1250 may be configured to detect, based on a measurement signal from a flex sensor 1220, an external flexing force being received at the flexible body 1210. In response to detecting the external flexing force being applied to the flexible body 1210, the control unit 1250 may be configured to determine whether to generate resistive feedback that resists the external flexing force. In response to a determination to generate resistive feedback, the control unit 1250 may be configured to activate the actuator 1240 to actuate a first surface of the first layer 1260 toward a second surface of the second layer 1270, wherein the second surface of the second layer 1270 faces the first surface of the first layer 1260. The actuation may increase the contact surface area between the array of micro-wedges on the first layer 1260 and the second surface of the second layer 1270.

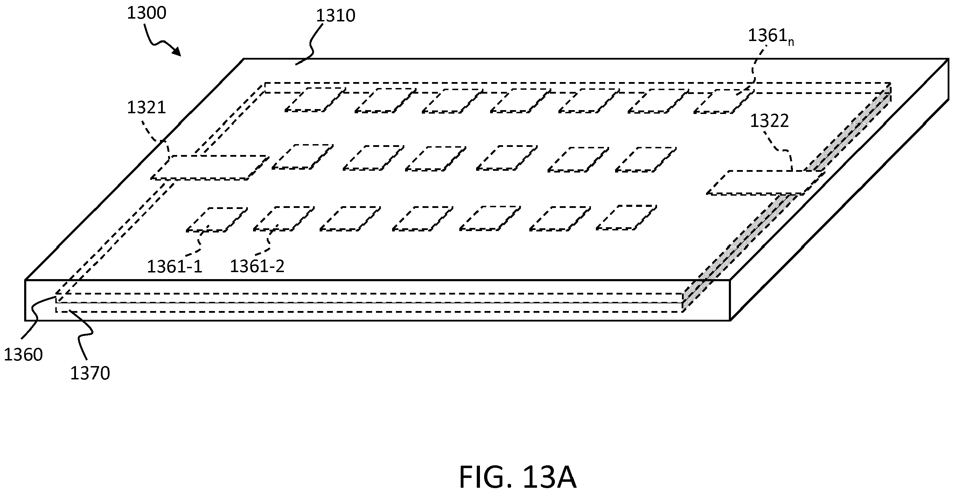

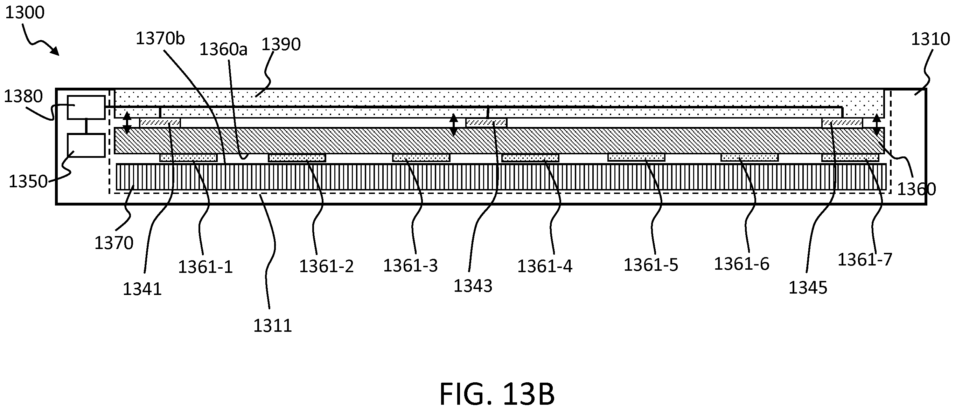

FIGS. 13A-13D depict a flexible user interface device 1300 that is a more specific embodiment of the flexible user interface device 1200 that may use an array of micro-wedges. The flexible user interface device 1300 includes a flexible body 1310 and a pair of flex sensors 1321, 1322 configured to sense an external flexing force being applied to the flexible body 1310. The flexible body 1310 may include a compartment 1311, cavity, or other space in which a first layer 1360 and a second layer 1370 are disposed. In an embodiment, as depicted in FIG. 13B, a plurality of actuators 1341, 1343, 1345 may be attached to the first layer 1360 and be configured to engage the first layer 1360 with the second layer 1370 by pressing the first layer against the second layer 1370. The plurality of actuators 1341, 1343, 1345 may also be attached to a support substrate 1390, which may also be referred to as a mounting substrate on which the actuators 1341, 1343, 1345 and the first layer 1360 are mounted. The flexible user interface device 1300 may further include an energy storage device 1380 for powering the actuators 1341, 1343, 1345, and a control unit 1350 for controlling when the actuators 1341, 1343, 1345 are activated.

In an embodiment, each layer of the first layer 1360 and the second layer 1370 may be formed from a flexible material, such as polyimide, or such as silicone, e.g., polydimethylsiloxane (PDMS). As stated above, an array of micro-wedges may be organized into patches on one of the layers. As depicted in FIGS. 13A and 13B, the first layer 1360 may have a plurality of patches 1361-1 through 1361-7 disposed on a surface 1360a of the first layer 1360. The patches 1361-1 through 1361-7 and the micro-wedges disposed thereon may be facing a second surface 1370b of the second layer 1370. Each patch of the patches 1361-1 through 1361-7 may have a sub-array of micro-wedges.

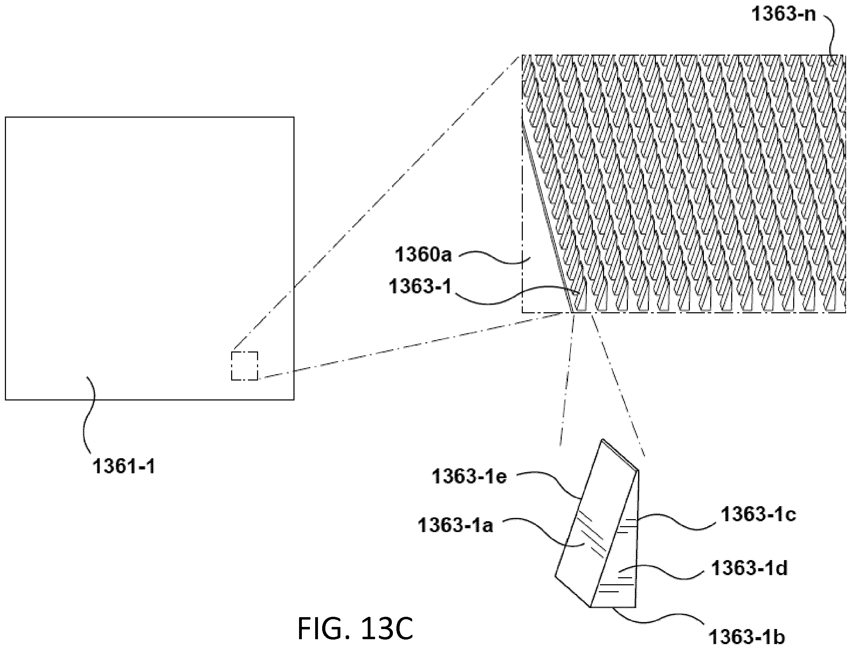

FIG. 13C illustrates a patch 1361-1 as a patch of micro-wedges, including micro-wedge 1363-1. In an embodiment, the micro-wedges may be formed by etching away material from a surface of the first layer 1360. Fabrication of such micro-wedges is discussed in more detail in Parness et al., "A microfabricated wedge-shaped adhesive array displaying gecko-like dynamic adhesion, directionality and long lifetime," Journal of the Royal Society (March 18, 2009), and in Hawkes et al., "Human climbing with efficiently scaled gecko-inspired dry adhesives," Royal Society Publishing (June 28, 2017), the entire contents of which are incorporated by reference herein. In an embodiment, the micro-wedges may be formed on a substrate, and the substrate may then be attached to the first layer 1360. In the embodiment of FIG. 13C, the micro-wedge 1363-1 may have a rectangular base 1363-1b that attaches the micro-wedge to the layer 1360, and a first pair of opposite surfaces 1363-1d, 1363-1e that are triangular in shape, and a second pair of opposite surfaces 1363-1a, 1363-1c that are rectangular in shape. In this example, one or more of the rectangular sides, e.g. 1363-1a, may further form an oblique angle with the surface 1360a of the layer 1360. In an embodiment, each dimension of the micro-wedge 1363-1, such as width or height, is in a range of 10 micron to 100 micron. The micro-wedge 1363-1 may be formed from, e.g., PDMS, or some other material.

In an embodiment, when the micro-wedge 1363-1 is undeformed, it may have a shape that tapers from the base 1363-1b of the micro-wedge to a tip at an end opposite the base 1363-1b of the micro-wedge. In an embodiment, each of the micro-wedges, including micro-wedge 1363-1, may be sufficiently flexible such that when they are pressed against another object, or that object presses against the micro-wedges, the micro-wedges bend or otherwise deform, as discussed below, so as to expose more surface area to contact the micro-wedge. That is, when the micro-wedge 1363-1 is deformed, a substantial portion of surface 1363-1a or of another surface may come into full contact with the object, thus increasing a level of contact and level of friction between the micro-wedge 1363-1 and the object.

More specifically, the actuators 1341, 1343, 1345 may be configured to engage layer 1360 and layer 1370, or more generally increase their level of engagement, by pressing layer 1360 against layer 1370. For instance, each of the actuators 1341, 1343, 1345 may be a MFC actuator that is configured to expand or contract along the arrows shown in FIG. 13B, which may point in a direction normal to the layer 1360. When the actuators 1341, 1343, 1345 expand, they may cause layer 1360 to engage with layer 1370, and more specifically cause the micro-wedges on the layer 1360 to engage with the layer 1370. When the layers 1360, 1370 are engaged, the micro-wedges that are on the layer 1360 may press against surface 1370b of the layer 1370, and may be deformed as a result.

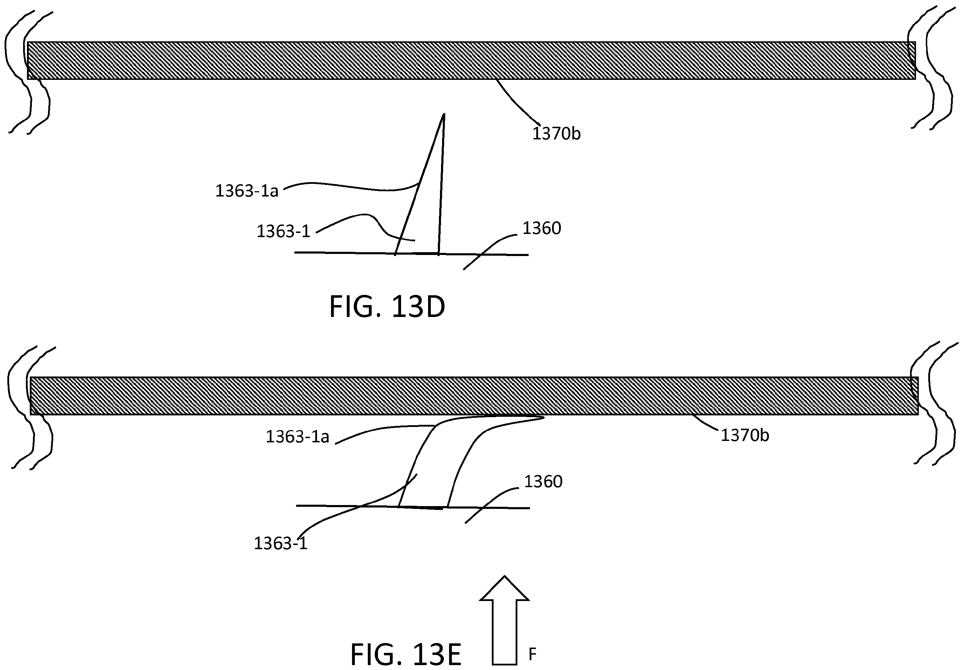

When the micro-wedges are not engaged or only minimally engaged with the layer 1370, they may present a small area of contact with surface 1370 and generate no adhesion or negligible adhesion. When loaded in a shear direction, the micro-wedges bend to create a larger surface contact area. For instance, FIG. 13D depicts micro-wedge 1363-1 before the layers 1360, 1370 are engaged with each other. In this instance, the micro-wedge 1363-1 may be upright, and may have no contact with the surface 1370b of layer 1370, or may contact the surface 1370 at only a tip of the micro-wedge 1363-1. FIG. 13E depicts the micro-wedge 1363-1 after the layers 1360, 1370 are engaged with each other, or more specifically after the micro-wedges on the layer 1360 are engaged with the layer 1370. The engagement may be caused by a force F provided by the actuators 1341, 1343, 1345 pressing the layer 1360 against the layer 1370. In this instance, the micro-wedge 1363-1 may be bent by the force F. The bending of the micro-wedge 1363-1 may cause a substantial portion of its surface 1363-1a to contact surface 1370b, thus increasing a surface contact area between the two layers 1360, 1370. Similarly, all of the other micro-wedges on the layer 1360 may also be deformed and increase a surface contact area with the surface 1370b of layer 1370. As a result, the amount of friction between the two layers 1360, 1370 may be increased, thus preventing or restricting the ability of the two layers 1360, 1370 to slide relative to each other. As a result, it may become more difficult to bend the two layers 1360, 1370. Thus, the two layers 1360, 1370 together may become stiffer when they are engaged or have an increased level of engagement. Thus, when a control unit determines that resistive feedback is to be generated, it may activate the actuators 1341, 1343, 1345 to press layer 1360 against layer 1370, or vice versa, in order to cause an increase in the level of engagement therebetween. As an example, the actuators 1341, 1343, 1345 may generate a force that is between 1 N and 2 N to engage the layers 1360, 1370. In this example, each patch of the plurality of patches may have an area of 140 cm2, and may be able to resist a shear force of up to 950 N.

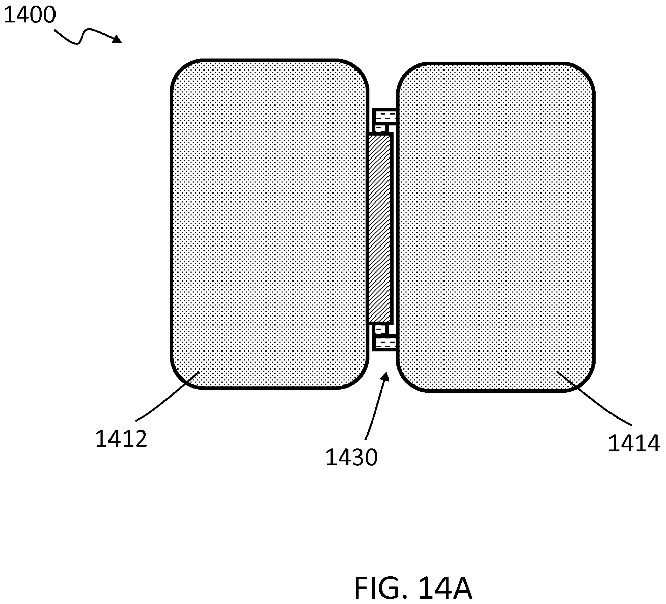

In one aspect of the embodiments herein, resistive feedback may be applied to a foldable device, such as an e-reader having two flaps that are foldable relative to each other. These embodiments may employ any of the air jamming, electroadhesion, smart material actuation, or other implementations discussed above. In some of these implementations, the foldable device may have a hinge, and resistive feedback may be applied at or around the hinge. For instance, FIG. 14A illustrates a foldable device 1400 having a hinge 1430, which may allow a first flap 1412 and a second flap 1414 to be foldable relative to each other. In some cases, the foldable device may have some of the same components as, e.g., the device 800 in FIG. 8, although the flaps 1412, 1414 may in some instances be stiff instead of flexible.

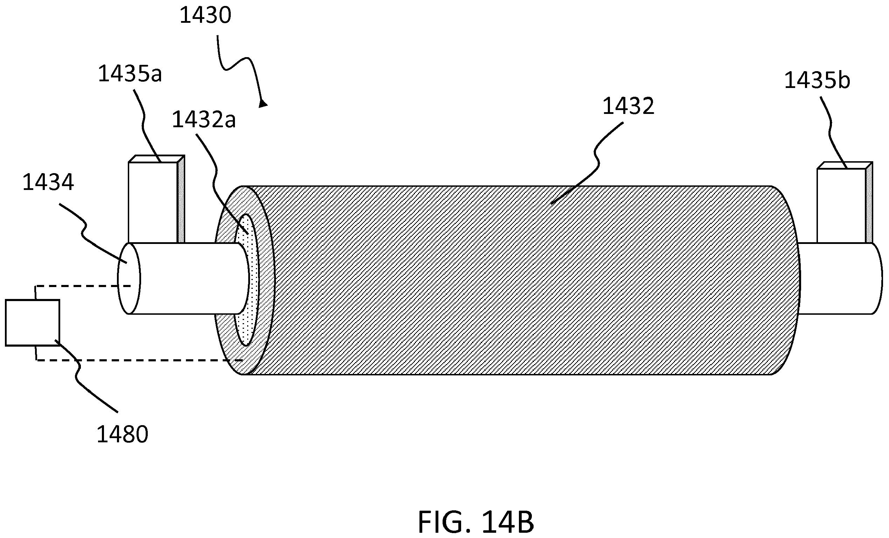

In an embodiment, resistive feedback may be created via electroadhesion at the hinge 1430. FIG. 14B depicts an example of the hinge 1430, which may include an inner shaft or axle 1434 that is inserted in an outer sleeve 1432. The inner shaft 1434 may be connected to the second flap 1414 via tabs 1435a, 1435b, while the outer sleeve 1432 may be connected to the first flap 1412. The inner shaft 1412 may be rotatable relative to the outer sleeve 1432. As a result, the two corresponding flaps 1412, 1414 that are connected to the hinge 1432 may be foldable by rotating relative to each other. FIG. 14B further depicts an energy storage device 1480 that may be used to apply an electric charge to at least one of the inner shaft 1434 and the outer sleeve 1432. In the embodiment of FIG. 14B, the outer sleeve 1432 may have an electrically insulating layer 1432a that electrically isolates the inner shaft 1434 from the outer sleeve 1432. In some cases, the energy storage device 1480 may, together with a control unit, form a signal that provides the electrical charge.

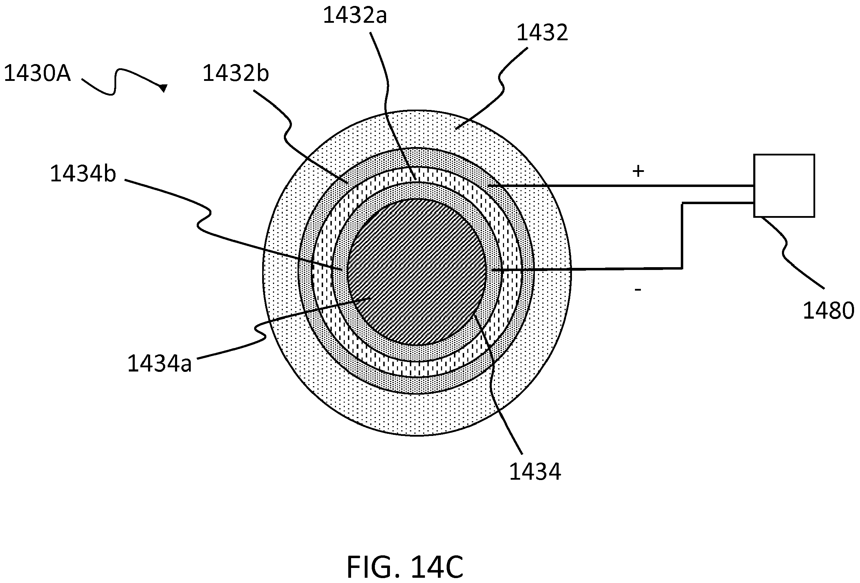

FIG. 14C depicts a hinge 1430A that may be a more specific embodiment of the hinge 1430. In this embodiment, the outer sleeve 1432 may have an electrode 1432b, and the inner shaft 1434 may also have an electrode 1434b. The two electrodes 1432b, 1434b may be concentric with each other and may be separated by the insulating layer 1432a, which may be part of the outer sleeve 1432. The energy storage device 1480 may apply opposite electrical charges to the electrodes 1432b, 1434b. In an embodiment, the opposite electrical charges may cause increased electroadhesion between the electrodes 1432b, 1434b and between the inner shaft 1434 and the outer sleeve 1432, in a manner similar to that depicted in FIG. 10. The increased amount of electroadhesion may increase an amount of resistance to relative rotation between the inner shaft 1434 and the outer sleeve 1432, which may be used to generate resistive feedback against an external force that is being applied to fold or unfold the foldable device 1400. The folding or unfolding of the device 1400 may also be referred to as closing or opening, respectively, of the device. In the embodiment of FIG. 14C, the inner shaft 1434 may have the electrode 1434b disposed around an electrically insulating core 1434a. In another embodiment, the entire inner shaft 1434 may be formed from a conductor such as metal.

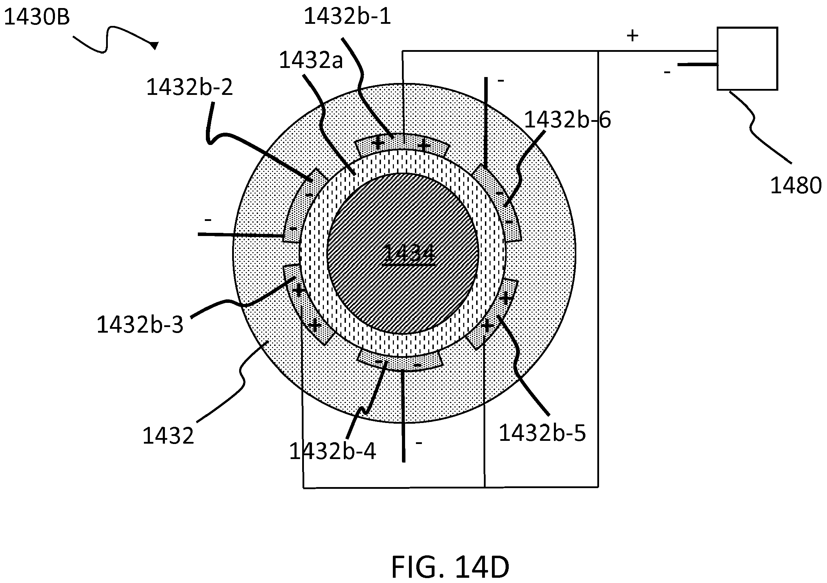

FIG. 14D depicts a hinge 1430B that is another embodiment of the hinge 1430. The hinge 1430B may have an outer sleeve 1432 with inter-digitated electrodes, in a manner similar to FIG. 9B. More specifically, the outer sleeve 1432 may have a first set of electrodes 1432b-1, 1432b-3, 1432b-5 that are provided with a first charge, and a second set of electrodes 1432b-2, 1432b-4, 1432b-6 that are provided with an opposite voltage. The first set of electrodes and the second set of electrodes may be arranged around the outer sleeve 1432 in an alternating fashion, so that an electrode that has a positive charge is directly adjacent to electrodes having a negative charge, and vice versa. In an embodiment, an AC signal may be applied to the electrodes 1432b-1 to 1432b-6. In such a situation, the first set of electrodes 1432b-1, 1432b-3, 1432b-5 may be provided with a first AC signal, and the second set of electrodes 1432b-2, 1432b-4, 1432b-6 may be provided with a second AC signal that is 180° out of phase with the first AC signal. When the electrical signals are applied to the electrodes 1432b-1 to 1432b-6, they may create electrostatic friction that may create resistive feedback.

In the embodiment of FIG. 14D, the inner shaft 1434 may be a single piece of conductive material, and the outer sleeve 1432 may have an electrically insulating layer 1432a that separates the inner shaft 1434 from the electrodes 1432b-1 to 1432b-6. In another embodiment, the inner shaft 1434 may be a single piece of electrically insulating material, and the outer sleeve 1432 may omit the electrically insulating layer 1432a.

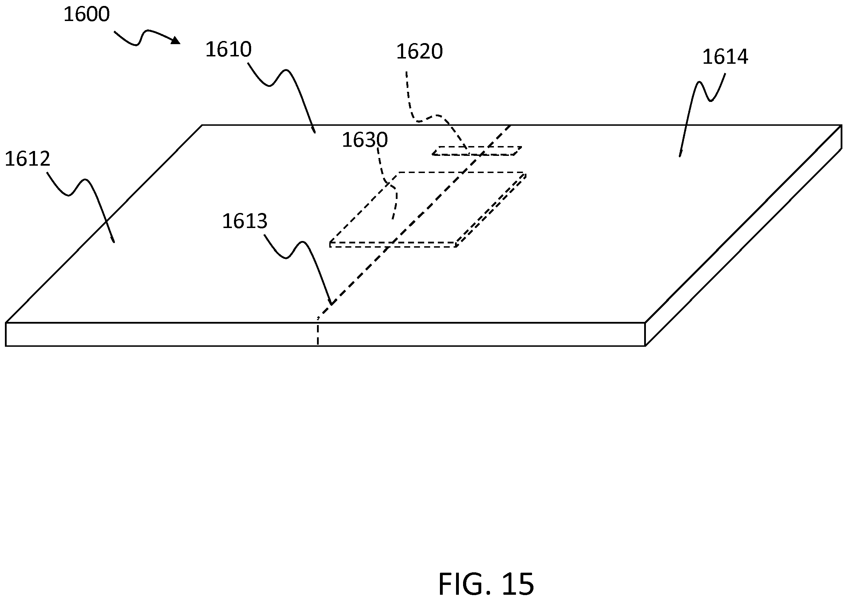

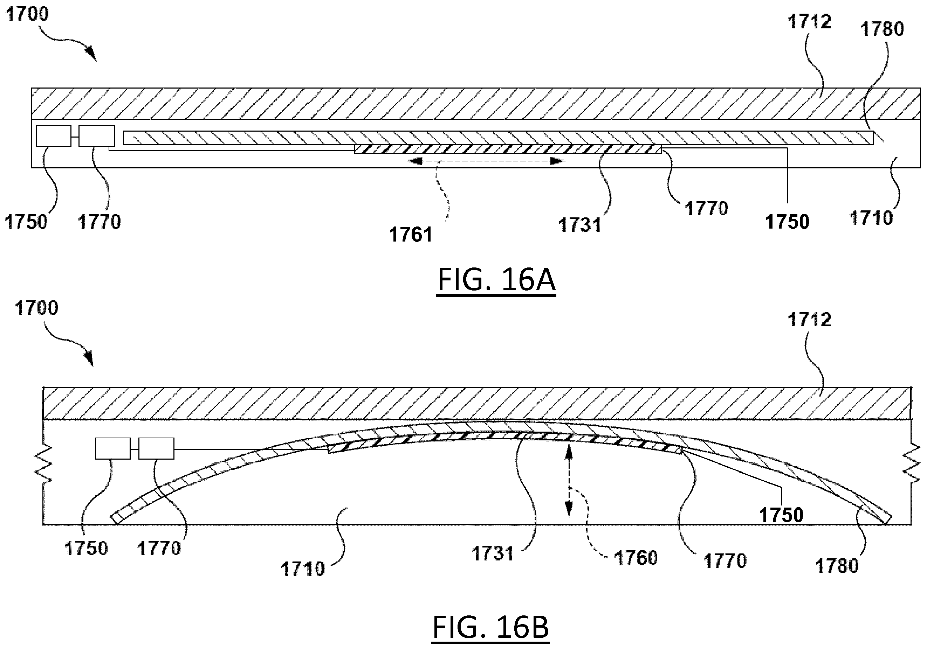

FIG. 15 depicts an embodiment in which air jamming is used to provide resistive feedback for a foldable device. More specifically, FIG. 16 illustrates a foldable device 1600 comprising a body 1610, which has a first flap 1612, a second flap 1614, and a crease 1613 formed in the body 1610, in a manner that is the same or similar to that in FIG. 15. The foldable device 1600 may further include an air sac 1630 that is disposed within the body 1610, or attached to a surface of the body 1610. The air sac 1630 may be the same or similar to the sacs 130 through 430 described above, and may overlap with the crease 1613.

In an embodiment, the foldable device 1600 may include a flex sensor 1620, such as a strain gauge, that is used to detect when an external force is being applied to close the foldable device. The foldable device 1600 may pump air out of the air sac 1630 in response to the external force. As a result, the air sac 1630 may increase in stiffness, which may provide resistive feedback against the external force.

While the above embodiments discuss providing resistive feedback against an external force, the techniques discussed herein may be more generally used to adjust a level of stiffness of a user interface device, and can be done independently of user interaction. For instance, the air jamming or electroadhesion embodiments discussed above may be used to lock a foldable device in an opened state, regardless of whether an external force is being applied to close the foldable device.

While one aspect of the embodiments described herein relates to providing resistive feedback, another embodiment may relate to generating active shape change or other deformation of a device. In some cases, the deformation may be in a normal direction, which may be along a thickness dimension of the device, and may be perpendicular to a front surface or back surface of the device. In some cases, the deformation may be in a lateral direction, which may be along a length or width dimension of the device. For instance, FIGS. 16A-16B illustrate a user interface device 1700 that is configured to generate deformation in a normal direction. More specifically, the user interface device 1700 may have an elastic body 1710, such as a body formed from a silicone shell or other elastomer material. In an embodiment, the flexible bodies 110 through 1310 discussed above may refer to a body that has the ability to be bent or otherwise flexed such that, e.g., the body has a curvature or is otherwise non-flat, while an elastic body may refer to a body that is able to be stretched or contracted (e.g., compressed) along a length, width, or thickness of the body. The elastic body may also be flexible, or may be stiff.

In FIGS. 16A and 16B, the flexible user interface device 1700 may further include a display layer 1712 that is disposed within or that forms part of the elastic body 1710, and include a flexible substrate 1780, a MFC actuator 1731, a control unit 1750, and an energy storage device 1770 that are disposed within the elastic body 1710. In some cases, the MFC actuator 1731 may be bonded to a center of a first surface of the flexible substrate 1780.

In an embodiment, the control unit 1750 may cause the deformation of the elastic body 1710 by activating the MFC actuator 1731. More specifically, the MFC actuator 1731 may include a layer of MFC material, and the user interface device 1700 may have two electrodes disposed on opposite sides of the layer of MFC material, along a length dimension or width dimension thereof. The control unit 1750 may be configured to cause the energy storage device 1770 to generate a voltage difference between the two electrodes. The voltage difference may cause the layer of MFC material to exert a contracting force along the axis 1761, which is an axis along a length dimension or width dimension of the layer of MFC material. Further, the layer of MFC material may be bonded at a first surface thereof to the flexible substrate 1780, such as a flexible board, so as to form a unimorph structure. The flexible substrate 1780 may be substantially unable to contract or stretch along the axis 1761, or at least much less able to do so than the layer of MFC material. Thus, the bonding between the first surface of the layer of MFC material and the flexible substrate 1780 may prevent contraction of the layer of MFC material at the first surface thereof, or at least cause any contraction at the first surface to be at a smaller magnitude relative the contraction of the MFC material at a second and opposite surface thereof. The contraction refers to contraction along the axis 1761. This constraint may convert the contracting force along the axis 1761 into a bending force on the flexible substrate 1780 and on the layer of MFC material. As a result, the flexible substrate 1780 and the MFC actuator 1731 may bend or otherwise flex to have a concave shape or convex shape, as illustrated in FIG. 16B. The bending may cause the flexible substrate 1780 to increase in height and exert a pushing force against the display layer 1712. The pushing force may be along a normal axis 1760 that is perpendicular to axis 1761, and may stretch the elastic body 1710 along the normal axis 1760.

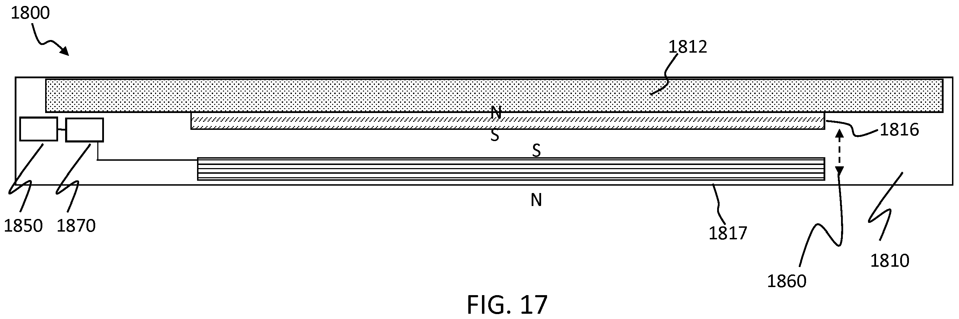

In an embodiment, one or more electromagnets may be used to cause deformation of a device in a normal direction. For instance, FIG. 17 depicts a user interface device 1800 that has an elastic body 1810, a display layer 1812, a permanent magnet 1816, an electromagnet 1817, a control unit 1850, and an energy storage device 1870. The elastic body 1810 may be similar to the elastic body 1710, and the electromagnet 1817 may be a conducive coil like those illustrated in FIG. 11. To create a deformation along the axis 1860, the control unit 1850 may cause the energy storage device 1870 to activate the electromagnet 1817 by providing electrical current thereto. The electrical current may cause the electromagnet 1817 to generate a magnetic field with a polarity that is opposite to the magnetic field of the permanent magnet 1816, as depicted in FIG. 17. The interaction between the magnetic fields may generate a force that causes the permanent magnet 1816 to be repelled by the electromagnet 1817, which stretches or otherwise deforms the elastic body 1810 along the axis 1860. In another example, the control unit 1850 may cause the electromagnet 1817 to generate a magnetic field with a polarity that is the same as that of the permanent magnet 1816. The resulting interaction between the magnetic fields in this example may cause the permanent magnet 1816 to be attracted to the electromagnet 1817, which may cause the elastic body 1810 to contract along the axis 1860. While the embodiment of FIG. 17 involves the permanent magnet 1816, another embodiment may replace the permanent magnet 1816 with an electromagnet.

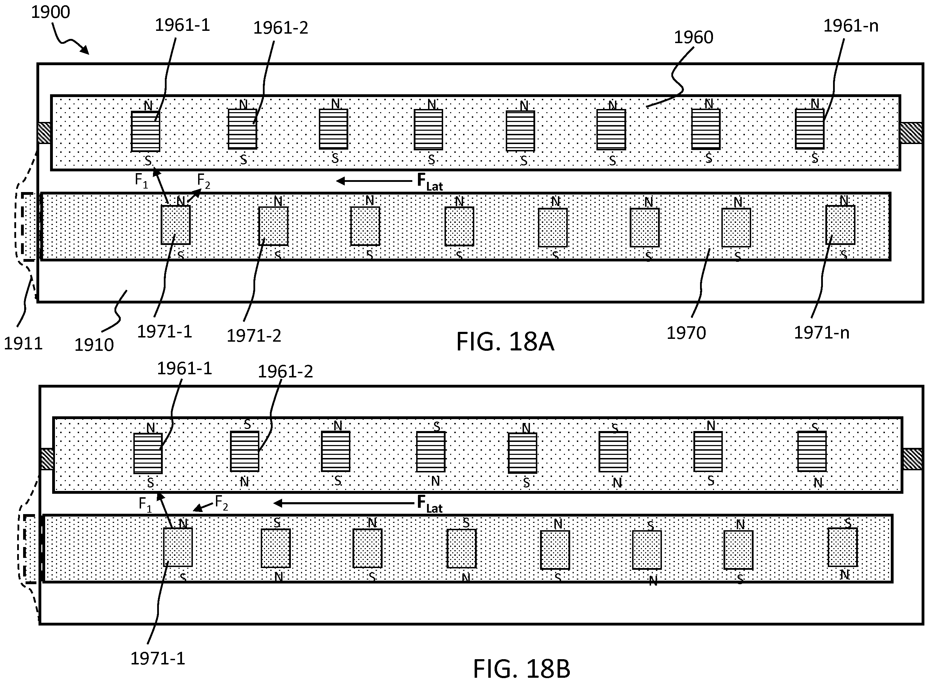

As discussed above, electromagnets may also be used to cause deformation in a lateral direction. For instance, FIGS. 18A and 18B depict a user interface device 1900 that is able to create such a deformation. The device 1900 includes an elastic body 1910, as well as a first layer 1960 and a second layer 1970 disposed within the elastic body 1910. In an embodiment, the elastic body 1910 may be made from a material that is stretchable, such as an elastomer. In an embodiment, the elastic body 1910 may have an elastic surface 1911 or other deformable surface. In some cases, the elastic surface 1911 may be part of an elastic membrane that forms a shell of the elastic body 1910. In an embodiment, layer 1970 may be a substantially rigid plate that can deform the elastic membrane when pushed against the surface 1911.

In an embodiment, the first layer 1960 may have a first electromagnet 1961-1 or a first set of electromagnets 1961-1 to 1961-n disposed on or within the layer 1960, and the second layer 1970 may have a first permanent magnet 1971-1 or a first set of permanent magnets 1971-1 to 1971-n disposed on or within the layer 1970. In another embodiment, the permanent magnets in the second layer 1970 may be replaced by electromagnets.

When the first set of electromagnets 1961-1 to 1961-n are activated, they may generate a force that attracts or repels the permanent magnets 1971-1 to 1971-n. For instance, both electromagnets 1961-1 and 1961-2 may generate forces F₁ and F₂, respectively, that attracts the permanent magnet 1971-1. The electromagnets 1961-1 to 1961-n and the permanent magnets 1971-1 to 1971-n are not aligned, so that the forces generated between them have both a lateral component and a normal component. FIG. 18A depicts this situation, in which both F₁ and F₂ have a lateral component. In some cases, the electromagnets 1961-1 and 1961-2 may be controlled or disposed so that force F₁ and F₂ are not equal. For instance, electromagnet 1961-1 may be controlled to generate a stronger magnetic field, or may be disposed within the layer 1960 to be closer to the permanent magnet 1971-1. As a result, F₁ and F₂ may produce a net lateral force F_{Lat}, as depicted in FIG. 18A, that actuates the layer 1970. In an embodiment, a net normal force may also be generated, but the user interface device 1900 may have a spacer that keeps layer 1970 from moving toward the layer 1960.

In an embodiment, the electromagnets 1961-1 to 1961-n may alternate in magnetic polarity, and the permanent magnets 1971-1 to 1971-n may also alternate in polarity, as illustrated in FIG. 18B. Such a configuration may be able to produce a stronger lateral force in some instances. For example, as depicted in FIG. 18B, the permanent magnet 1971-1 in this configuration is not only attracted toward one side by electromagnet 1961-1, but is also repelled towards the same side by electromagnet 1961-2. The resulting configuration may result in a stronger net lateral force F_{Lat}.

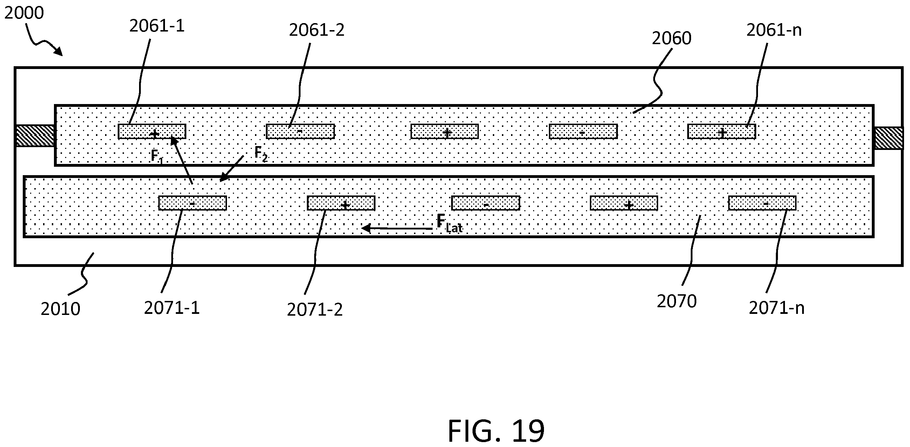

FIG. 19 illustrates an embodiment in which electrodes may be used to create a lateral deformation. More specifically, FIG. 19 depicts a user interface device 2000 having an elastic body 2010 that includes a first layer 2060 and a second layer 2070. These components may be the same or similar to the elastic body 1910, layer 1960, and layer 1970, respectively. The first layer 2060 may have a first electrode 2061-1 or first set of electrodes 2061-1 to 2061-n disposed within or on the first layer 2060, and the second layer 2070 may have a second electrode 2071-1 or second set of electrodes 2071-1 to 2071-n disposed within or on the second layer 2070. The first set of electrodes 2061-1 to 2061-n may be out of alignment with the second set of electrodes 2071-1 to 2071-n so that their interaction generates a lateral force. In an embodiment, the user interface device 2000 may alternate between providing a positive charge and a negative charge to the first set of electrodes 2061-1 to 2061-n. The device 2000 may likewise alternate between providing a positive charge and a negative charge to the second set of electrodes 2071-1 to 2071-n. As depicted in FIG. 19, electrode 2071-1 may be attracted via force F₁ to a positive charge on electrode 2061-1, and repelled via force F₂ by a negative charge on electrode 2061-2. In some instances, the electrical charges may be applied such that, for at least one electrode of the second set of electrodes 2071-1 to 2071-n, the two closest electrodes from the first set of electrodes 2061-1 to 2061-n have opposite charges. As discussed above with respect to FIGS. 18A and 18B, the forces F₁, F₂ between the electrodes may have a normal component and a lateral component. These forces may add up to have a net lateral force F_{Lat} that actuates the layer 1970 to generate a deformation in a lateral direction.

In an embodiment, the resistive feedback or deformation effects discussed above may be combined with a vibrotactile effect. For instance, any of the devices discussed herein may incorporate a vibrotactile actuator, such as a linear resonant actuator, that is configured to generate a vibrotactile haptic effect. In some cases, the vibrotactile haptic effect may be generated simultaneously with the resistive feedback or deformation effect.

Additional discussion of various embodiments is presented below:
Embodiment 1 relates to a flexible user interface device, comprising:
   - a flexible body;
   - a flex sensor;
   - a sac;
   - an air pump; and
   - a control unit.
   The flex sensor is disposed within or attached to the flexible body and configured to sense the flexible body receiving an external flexing force.
   The sac has a flexible membrane, wherein the sac is disposed within the flexible body or attached to a surface thereof, wherein the sac is configured to hold a volume of air and includes a stack of at least two layers of material disposed within the sac, wherein the sac decreases in flexibility when air is pumped out of the sac, and increases in flexibility when air is restored into the sac.
   The air pump is attached to the sac and configured, when activated, to pump air into or out of the sac.
   The control unit is in communication with the flex sensor and the air pump, and configured
   - to detect, based on a measurement signal from the flex sensor, the flexible body receiving the external flexing force,
   - in response to detecting the flexible body receiving the external flexing force, to determine whether to generate resistive feedback that resists the external flexing force, and
   - in response to a determination to generate the resistive feedback, to cause the layers of material in the sac to increase in stiffness by activating the air pump to pump air out of the sac.
Embodiment 2 includes the flexible user interface device of embodiment 1, and further comprises a flexible display layer disposed within the flexible body, wherein the flexible display layer is an organic light emitting device (OLED) display layer, and wherein the flexible body is formed from a flexible substrate or a flexible shell.
Embodiment 3 includes the flexible user interface device of embodiment 1 or 2, wherein each layer of the stack of layers is a woven layer having a plurality of fibers that are interlaced with each other.
Embodiment 4 includes the flexible user interface device of embodiment 3, wherein each layer of the stack is a layer of fabric.
Embodiment 5 includes the flexible user interface device of embodiment 3 or 4, wherein the stack includes at least fifteen woven layers.
Embodiment 6 includes the flexible user interface device of any one of embodiments 1-5, wherein the control unit, in response to the determination to generate resistive feedback, is configured to cause the air pump to decrease air pressure within the sac to a value that is less than or equal to 10 inches of mercury (inHg).
Embodiment 7 includes the flexible user interface device of embodiment 6, wherein the control unit is configured to cause the air pump to decrease air pressure within the sac to a value that is less than or equal to 5 inches of mercury (inHg), to cause the stack of layers in the sac to become substantially unbendable.
Embodiment 8 includes the flexible user interface device of embodiment 6 or 7, wherein the control unit is configured to determine a magnitude of the external flexing force being received at the flexible body, and is configured to cause the air pump to decrease air pressure within the sac to a level that is based on the magnitude of the external flexing force.
Embodiment 9 includes the flexible user interface device of any one of embodiments 1-8, wherein the flex sensor is a strain gauge, and the control unit is configured to control an amount of time that the air pump is activated based on the measurement signal by the strain gauge.
Embodiment 10 includes the flexible user interface device of any one of embodiments 1-9, wherein the stack of layers in the sac is flexible when the air pressure within the sac is substantially equal to or greater than 1 atmosphere.
Embodiment 11 relates to a flexible user interface device, comprising:
   - a flexible body;
   - an actuator; and
   - a control unit.
   The actuator has a layer of actuatable material and two electrodes disposed on opposite ends of the layer of actuatable material, wherein the actuatable material is configured to generate a stretching force or a contracting force along the layer of actuatable material when a voltage difference is generated between the opposite ends of the actuatable material via the two electrodes, wherein a first surface of the layer of the actuatable material is bonded to the flexible body.
   The control unit is configured
   - to detect the flexible body receiving a first flexing force that is an external flexing force,
   - in response to detecting the flexible body receiving the external flexing force, to determine whether to generate resistive feedback that resists the external flexing force,
   - in response to a determination to generate the resistive feedback, to activate the actuator by generating the voltage difference between the opposite ends of the actuatable material via the two electrodes, wherein the voltage difference causes the layer of actuatable material to exert a second flexing force that resists the first flexing force.
Embodiment 12 includes the flexible user interface device of embodiment 11, further comprising a flexible display layer disposed within the flexible body, wherein the flexible display layer is an organic light emitting device (OLED) display layer, and wherein the flexible body is formed from a flexible substrate or a flexible shell.
Embodiment 13 includes the flexible user interface device of embodiment 12, wherein the flexible body is formed from the flexible substrate, wherein the flexible substrate has a crease, and wherein the actuator is disposed between the crease and an edge or corner of the flexible substrate.
Embodiment 14 includes the flexible user interface device of embodiment 13, wherein the actuator does not overlap with the crease.
Embodiment 15 includes the flexible user interface device of any one of embodiments 12-14, wherein the layer of actuatable material is a layer of piezoelectric material configured to exert the stretching force along a length or width of the layer when the voltage difference is generated between opposite ends of the actuatable material, and wherein the bonding between the first surface of the layer of actuatable material and the flexible substrate prevents stretching of the layer of actuatable material at the first surface thereof, or causes the layer of actuatalbe material to stretch by a smaller magnitude at the first surface thereof than at a second and opposite surface thereof, such that the bonding converts the stretching force generated by the actuatable material to a bending force on the flexible substrate, wherein the bending force resists the external flexing force.
Embodiment 16 includes the flexible user interface device of embodiment 15, wherein the layer of piezoelectric material is a layer of macrofiber composite (MFC) material that includes a plurality of piezoelectric fibers embedded in a polymeric material.
Embodiment 17 includes the flexible user interface device of embodiment 16, wherein the control unit is configured, before the actuator is activated, to detect a measurement signal generated by the MFC material, wherein the measurement signal is generated by the MFC material in response to the MFC material being flexed, and wherein the control unit is configured to detect the external flexing force based on the measurement signal generated by the MFC material.
Embodiment 18 includes the flexible user interface device of any one of embodiments 13-17, wherein the control unit, in response to the determination to generate the resistive feedback, is configured to cause the voltage difference between the opposite ends of the actuatable material to have a magnitude that is based on a magnitude of the external flexing force.
Embodiment 19 includes the flexible user interface device of any one of embodiments 11-14, wherein the actuator is an electroactive polymer (EAP) actuator.
Embodiment 20 includes the flexible user interface device of any one of embodiments 11-19, further comprising a flex sensor separate from the actuator, and disposed within or attached to the flexible body and configured to sense the flexible body receiving the external flexing force, wherein the control unit is configured to detect the external flexing force based on a measurement signal from the flex sensor.
Embodiment 21 relates to a flexible user interface device, comprising:
   - a flexible body;
   - a stack of at least a first layer and a second layer that are disposed within the flexible body;
   - a flex sensor; and
   - a control unit.
   The stack of includes at least one electrode disposed within or bonded to the first layer, wherein the at least one electrode is configured to generate electrostatic adhesion between the first layer and the second layer to prevent the first layer from sliding relative to the second layer and vice versa.
   The flex sensor is disposed within or attached to the flexible body and configured to sense the flexible body receiving an external flexing force.
   The control unit is in communication with the flex sensor and configured
   - to detect, based on a measurement signal from the flex sensor, the flexible body receiving the external flexing force,
   - in response to detecting the flexible body receiving the external flexing force, to determine whether to generate resistive feedback that resists the external flexing force,
   - in response to a determination to generate the resistive feedback, to apply an electrical signal to the at least one electrode to generate electrostatic adhesion between the first layer and the second layer and thereby prevent the first layer from sliding relative to the second layer and vice versa,
   The first layer and the second layer are configured to be able to slide relative to each other when no electrical signal is being provided to the at least one electrode and the flexible body is being flexed.
Embodiment 22 includes the flexible user interface device of embodiment 21, wherein the at least one electrode comprises a plurality of electrodes, wherein the first layer of the stack comprises an electrically insulating material, and wherein the plurality of electrodes are embedded in or bonded to the electrically insulating material of the first layer.
Embodiment 23 includes the flexible user interface device of embodiment 21 or 22, wherein the second layer consists essentially of electrically insulating material.
Embodiment 24 includes the flexible user interface device of embodiment 21 or 22, wherein the second layer consists essentially of an additional electrode separate from the plurality of electrodes.
Embodiment 25 includes the flexible user interface device of any one of embodiments 21-24, wherein the first layer and the second layer form a first pair of layers, and wherein the stack includes at least an additional four pairs of layers, wherein each of the four pairs has the same structure as the first pair of layers.
Embodiment 26 includes the flexible user interface device of any one of embodiments 21-25, wherein the at least one electrode is configured to generate an adhesion force of at least 1.5 N between the first layer and the second layer.
Embodiment 27 relates to a flexible user interface device, comprising:
   - a flexible body;
   - a stack of at least a first layer and a second layer that are disposed within the flexible body;
   - a flex sensor; and
   - a control unit.
   The stack includes a first electromagnet disposed within or bonded to the first layer and a second electromagnet disposed within or bonded to the second layer, wherein the first electromagnet and the second electromagnet are configured to generate electromagnetic adhesion between the first layer and the second layer to prevent the first layer from sliding relative to the second layer and vice versa.
   The flex sensor is disposed within or attached to the flexible body and configured to sense the flexible body receiving an external flexing force.
   The control unit is in communication with the flex sensor and configured
   - to detect, based on a measurement signal from the flex sensor, the flexible body receiving the external flexing force,
   - in response to detecting the flexible body receiving the external flexing force, to determine whether to generate resistive feedback that resists the external flexing force,
   - in response to a determination to generate the resistive feedback, to apply respective electrical signals to the first electromagnet and the second electromagnet to generate electromagnetic adhesion between the first layer and the second layer and thereby prevent the first layer from sliding relative to the second layer and vice versa,
   The first layer and the second layer are configured to be able to slide relative to each other when no electrical signal is being provided to at least one of the first electromagnet or the second electromagnet, and the flexible body is being flexed.
Embodiment 28 includes the flexible user interface device of embodiment 27, wherein the first electromagnet is one of a first plurality of electromagnets embedded in or bonded to the first layer, and the second electromagnet is one of a second plurality of electromagnets embedded in or bonded to the second layer and aligned with respective electromagnets of the first plurality of electromagnets, wherein the control unit, in response to a determination to generate resistive feedback, is configured to cause a pair of aligned electromagnets of the first plurality of electromagnets and the second plurality of electromagnets, respectively, to generate respective magnetic fields that are opposite in polarity.
Embodiment 29 relates to a flexible user interface device, comprising:
   - a flexible body;
   - a stack of at least a first layer and a second layer that are disposed within the flexible body;
   - a flex sensor; and
   - a control unit.
   The first layer includes electrically insulating material and a first electrode bonded to the electrically insulating material. The second layer includes a second electrode that is disposed within or forms the second layer, wherein the first electrode and the second electrode are configured to generate electrostatic adhesion between the first layer and the second layer to prevent the first layer from sliding relative to the second layer and vice versa.
   The flex sensor is disposed within or attached to the flexible body and configured to sense the flexible body receiving an external flexing force.
   The control unit is in communication with the flex sensor and configured
   - to detect, based on a measurement signal from the flex sensor, the flexible body receiving the external flexing force,
   - in response to detecting the flexible body receiving the external flexing force, to determine whether to generate resistive feedback that resists the external flexing force,
   - in response to a determination to generate the resistive feedback, to apply a first charge to the first electrode, and to apply a second and opposite charge to the second electrode to generate electrostatic adhesion between the first layer and the second layer and thereby prevent the first layer from sliding relative to the second layer and vice versa,
   The first layer and the second layer are configured to be able to slide relative to each other when no electrical signal is being provided to first electrode and the second electrode and the flexible body is being flexed.
Embodiment 30 includes the flexible user interface device of embodiment 29, wherein the first electrode is the only electrode included in the first layer, and has an area substantially equal to an area of the first layer, and the second layer consists essentially of the second electrode.
Embodiment 31 relates to flexible user interface device, comprising:
   - a flexible body;
   - a stack of a first layer and a second layer disposed within the flexible body;
   - one or more actuators;
   - a flex sensor; and
   - a control unit.
   The first layer has an array of micro-wedges disposed on a first surface of the first layer.
   The one or more actuators are configured to actuate the first surface of the first layer toward a second surface of the second layer to engage the first layer and the second layer, wherein the array of micro-wedges are configured to deform when the first and second surfaces are being actuated toward each other, wherein deformation of the array of micro-wedges increases a contact surface area between the array of micro-wedges of the first layer and the second surface of the second layer relative to when the first and second surfaces were not being actuated toward each other, and wherein the first layer and the second layer are configured to slide relative to each other when the one or more actuators are not activated and the flexible body is being flexed;
   The flex sensor is embedded in or attached to the flexible body and configured to sense the flexible body receiving an external flexing force.
   The control unit is configured
   - to detect, based on a measurement signal from the flex sensor, the flexing body receiving the external flexing force,
   - in response to detecting the flexible body receiving the external flexing force, to determine whether to generate resistive feedback that resists the external flexing force, and
   - in response to a determination to generate resistive feedback, to activate the one or more actuators to actuate the first surface of the first layer toward the second surface of the second layer or vice versa so as to increase the contact surface area between the array of micro-wedges on the first layer and the second surface of the second layer.
Embodiment 32 includes the flexible user interface device of embodiment 31, wherein each micro-wedge of the array of micro-wedges has a dimension that is less than 0.1 mm.
Embodiment 33 includes the flexible user interface device of embodiment 32, wherein all dimensions of each micro-wedge of the array of micro-wedges is less than 0.1 mm.
Embodiment 34 includes the flexible user interface device of embodiment 31 or 32, wherein each micro-wedge of the array of micro-wedges is formed from silicone.
Embodiment 35 includes the flexible user interface device of any one of embodiments 31-34, wherein the array of micro-wedges includes at least one thousand micro-wedges.
Embodiment 36 includes the flexible user interface device of any one of embodiments 31-35, wherein the array of micro-wedges are divided into a plurality of separate patches, each patch of the separate patches including a substrate bonded to the first layer, wherein a sub-array of the array of micro-wedges are formed from the substrate.
Embodiment 37 includes the flexible user interface device of any one of embodiments 31-36, wherein the stack includes at least five layers, wherein at least four of the five layers has an array of micro-wedges protruding from a surface of the respective layer.
Embodiment 38 includes the flexible user interface device of any one of embodiments 31-37, wherein each of the first layer and the second layer has an area of at least 140 cm².
Embodiment 39 includes the flexible user interface device of any one of embodiments 31-38, wherein the one or more actuators are configured to press the first layer against the second layer or vice versa with a force having a magnitude of at least 1 N.
Embodiment 40 relates to a user interface device, comprising:
   - an elastic body able to undergo deformation that stretches the elastic body;
   - a control unit; and
   - an actuator
   The actuator has a flexible substrate bonded to a center of a first surface of a layer of actuatable material, the actuator further having two electrodes disposed on opposite ends of the layer of actuatable material, wherein the actuatable material is configured to generate a stretching force or a contracting force along the layer when a voltage difference is generated between the opposite ends of the actuatable material via the two electrodes.
   The bonding between the first surface of the layer of actuatable material and the flexible substrate prevents stretching and contracting of the layer of actuatable material at the first surface thereof, or causes the layer of actuatable material to stretch or contract by a smaller magnitude at the first surface thereof than at a second and opposite surface thereof, such that the bonding converts the stretching or contracting force generated by the actuatable material to a bending force on the flexible substrate that bends the flexible substrate into concave or a convex shape
   The control unit is configured to determine whether to generate a deformation haptic effect and, in response to the determination to generate the deformation haptic effect, to generate the voltage difference between the opposite ends of the layer of the actuatable material to bend the flexible substrate into the concave or the convex shape, which causes the flexible substrate to stretch the elastic body.
Embodiment 41 includes the flexible user interface device of embodiment 40, wherein the bending of the flexible substrate into the concave or the convex shape causes the flexible substrate to press against an inner surface of the elastic body.
Embodiment 42 includes the flexible user interface device of embodiment 40 or 41, wherein the actuatable material is a macrofiber composite (MFC) material that includes a plurality of piezoelectric fibers embedded in a polymeric material.
Embodiment 43 relates to a user interface device, comprising:
   - an elastic body able to undergo deformation that stretches the elastic body;
   - a control unit; and
   - an actuator.
   The actuator includes a first layer with a first plurality of electrodes disposed on or within the first layer, and includes a second layer with a second plurality of electrodes disposed on or within the second layer, wherein the first layer is slidable relative to the second layer when the actuator is activated.
   The control unit is configured to activate the actuator by applying charges on the first plurality of electrodes and charges on the second plurality of electrodes in a manner that causes the first plurality of electrodes to be attracted to the second plurality of electrodes in a direction that causes the first layer to slide relative to the second layer or vice versa.
   The sliding of the first layer relative to the second layer, or vice versa, causes the deformation that stretches the elastic body.
Embodiment 44 includes the user interface device of embodiment 43, wherein the first layer is suspended over the second layer in a manner that allows the first layer and the second layer to slide relative to each other.
Embodiment 45 includes the user interface device of embodiment 43 or 44, wherein the control unit is configured to cause, for at least one electrode of the first plurality of electrodes, opposite respective charges to be applied to two electrodes of the second plurality of electrodes that are closest to the at least one electrode.
Embodiment 46 relates to user interface device, comprising:
   - an elastic body able to undergo deformation that stretches the elastic body;
   - a control unit; and
   - an actuator that includes a first layer with a first plurality of electromagnets disposed on or within the first layer, and includes a second layer with a second plurality of electromagnets disposed on or within the second layer, wherein the first layer is slidable relative to the second layer when the actuator is activated,
   The control unit is configured to activate the actuator by activating the first plurality of electromagnets and the second plurality of electromagnets in a manner that causes the first plurality of electromagnets to be attracted to the second plurality of electromagnets in a direction that causes the first layer to slide relative to the second layer or vice versa.
   The sliding of the first layer relative to the second layer, or vice versa, causes the deformation that stretches the elastic body.
Embodiment 47 includes the user interface device of embodiment 46, wherein the control unit is configured to cause, for at least one electromagnet of the first plurality of electromagnets, magnetic fields of opposite respective polarities to be generated at two electromagnets of the second plurality of electromagnets that are closest to the at least one electromagnet.
Embodiment 48 relates to a flexible user interface device, comprising a flexible body, a flex sensor, and a control unit. The flex sensor is disposed within or attached to the flexible body and is configured to sense the flexible body receiving an external flexing force. The control unit in communication with the flex sensor and is configured to detect, based on a measurement signal from the flex sensor, the flexible body receiving the external flexing force. The control unit is further configured, in response to detecting the flexible body receiving the external flexing force, to determine whether to generate resistive feedback that resists the external flexing force. The control unit is also configured, in response to a determination to generate the resistive feedback, to cause the flexible body to increase in stiffness so as to resist the external flexing force.

While various embodiments have been described above, it should be understood that they have been presented only as illustrations and examples of the present invention, and not by way of limitation. It will be apparent to persons skilled in the relevant art that various changes in form and detail can be made therein without departing from the spirit and scope of the invention. Thus, the breadth and scope of the present invention should not be limited by any of the above-described exemplary embodiments, but should be defined only in accordance with the appended claims and their equivalents. It will also be understood that each feature of each embodiment discussed herein, and of each reference cited herein, can be used in combination with the features of any other embodiment. All patents and publications discussed herein are incorporated by reference herein in their entirety.

## Claims

1. A flexible user interface device, comprising:
a flexible body;
an actuator having a layer of actuatable material and two electrodes disposed on opposite ends of the layer of actuatable material, wherein the actuatable material is configured to generate a stretching force or a contracting force along the layer of actuatable material when a voltage difference is generated between the opposite ends of the actuatable material via the two electrodes, wherein a first surface of the layer of the actuatable material is bonded to the flexible body; and
a control unit configured
to detect the flexible body receiving a first flexing force that is an external flexing force,
in response to detecting the flexible body receiving the external flexing force, to determine whether to generate resistive feedback that resists the external flexing force,
in response to a determination to generate the resistive feedback, to activate the actuator by generating the voltage difference between the opposite ends of the actuatable material via the two electrodes, wherein the voltage difference causes the layer of actuatable material to exert a second flexing force that resists the first flexing force.

2. The flexible user interface device of claim 1, further comprising a flexible display layer disposed within the flexible body, wherein the flexible display layer is an organic light emitting device (OLED) display layer, and wherein the flexible body is formed from a flexible substrate or a flexible shell.

3. The flexible user interface device of claim 2, wherein the flexible body is formed from the flexible substrate, wherein the flexible substrate has a crease, and wherein the actuator is disposed between the crease and an edge or corner of the flexible substrate.

4. The flexible user interface device of claim 3, wherein the actuator does not overlap with the crease.

5. The flexible user interface device of any one of claims 2-4, wherein the layer of actuatable material is a layer of piezoelectric material configured to exert the stretching force along a length or width of the layer when the voltage difference is generated between opposite ends of the actuatable material, and wherein the bonding between the first surface of the layer of actuatable material and the flexible substrate prevents stretching of the layer of actuatable material at the first surface thereof, or causes the layer of actuatalbe material to stretch by a smaller magnitude at the first surface thereof than at a second and opposite surface thereof, such that the bonding converts the stretching force generated by the actuatable material to a bending force on the flexible substrate, wherein the bending force resists the external flexing force.

6. The flexible user interface device of claim 5, wherein the layer of piezoelectric material is a layer of macrofiber composite (MFC) material that includes a plurality of piezoelectric fibers embedded in a polymeric material,

7. The flexible user interface device of claim 6, wherein the control unit is configured, before the actuator is activated, to detect a measurement signal generated by the MFC material, wherein the measurement signal is generated by the MFC material in response to the MFC material being flexed, and wherein the control unit is configured to detect the external flexing force based on the measurement signal generated by the MFC material.

8. The flexible user interface device of any one of claims 3-7, wherein the control unit, in response to the determination to generate the resistive feedback, is configured to cause the voltage difference between the opposite ends of the actuatable material to have a magnitude that is based on a magnitude of the external flexing force.

9. The flexible user interface device of any one of claims 1-4, further comprising a flex sensor separate from the actuator, and disposed within or attached to the flexible body and configured to sense the flexible body receiving the external flexing force, wherein the control unit is configured to detect the external flexing force based on a measurement signal from the flex sensor.

10. The flexible user interface device of any one of claims 1-9, further comprising a flex sensor separate from the actuator, and disposed within or attached to the flexible body and configured to sense the flexible body receiving the external flexing force, wherein the control unit is configured to detect the external flexing force based on a measurement signal from the flex sensor.
